(19)

Europäisches
Patentamt
European
Patent Office
Office européen
des brevets

(11) **EP 2 180 434 A1**

(12) **EUROPEAN PATENT APPLICATION**
published in accordance with Art. 153(4) EPC

(43) Date of publication:
**28.04.2010 Bulletin 2010/17**

(21) Application number: **07822886.3**

(22) Date of filing: **02.08.2007**

(51) Int Cl.:
*G06N 3/12* (2006.01)          *G11C 8/16* (2006.01)

(86) International application number:
**PCT/ES2007/000478**

(87) International publication number:
**WO 2009/022024 (19.02.2009 Gazette 2009/08)**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicants:
• **Llopis Llopis, Jose Daniel
Avenida Cortes Valencianas n°35
Piso 5a, Puerta 29a
46015 Valencia (ES)**
• **Llopis Llopis, Carlos
Avenida Cortes Valencianas n°35
Piso 5a, Puerta 29a
46015 Valencia (ES)**
• **Llopis Llopis, Silvia
Avenida Cortes Valencianas n°35
Piso 5a, Puerta 29a
46015 Valencia (ES)**

(72) Inventors:
• **Llopis Llopis, Jose Daniel
Avenida Cortes Valencianas n°35
Piso 5a, Puerta 29a
46015 Valencia (ES)**
• **Llopis Llopis, Carlos
Avenida Cortes Valencianas n°35
Piso 5a, Puerta 29a
46015 Valencia (ES)**
• **Llopis Llopis, Silvia
Avenida Cortes Valencianas n°35
Piso 5a, Puerta 29a
46015 Valencia (ES)**

(74) Representative: **Ungria Lopez, Javier et al
c/o UNGRIA Patentes y Marcas, S.A.,
Avda. Ramon y Cajal, 78
28043 Madrid (ES)**

(54) **ELECTRONIC SYSTEM FOR EMULATING THE CHAIN OF THE DNA STRUCTURE OF A CHROMOSOME**

(57)    It is **characterized in that** it comprises means of binary encoding of the four types of nucleotides (A, G, C, T) which compose the strands, so that the nucleotides which form complementary linkages are assigned complementary codes; and include storage units (1) of a code of a nucleotide and of its complement, connecting said storage units in series to form the chain of nucleotides which constitute each strand of a "DNA" chain and thus obtain its electronic structure and permit selective access to a nucleotide, to a strand and to the two strands which compose the "DNA" chain.

It is applied in any problem that can be represented by a graph which is encoded in the storage units (1), to permit resolving problems in the calculation of trajectories in parallel form and in polynomial time, which today are unsolvable.

FIG. 3

EP 2 180 434 A1

**Description**

<u>OBJECT OF THE INVENTION</u>

The present invention, as expressed in the heading of this specification, has the object of providing an electronic system to emulate the chain of the "DNA" structure, to permit resolving problems of computing with "DNA", which, in the case of the invention, is inorganic "DNA" since it is materialized by electronic circuits and not by organic "DNA", as is done conventionally, and thus take advantage of the characteristics of the organic nature of "DNA" from an inorganic "DNA".

The invention consists of a hardware system which provides an electronic "DNA" structure, which permits resolving problems of trajectories, networks and flows, which are used in calculating trajectories in "GPS" (Global Positioning System) systems, calculation of routes in land, maritime or aerial navigators, and also in problems of industrial control in production and optimization processes of the industrial flows or work.

In general, the invention is applicable to the resolution of any problem that may be represented by graphs which are associated to the "DNA" structure chain, as will be described below.

<u>BACKGROUND OF THE INVENTION</u>

Mathematics and computing go hand in hand in an area of science which is known as graph theory. Graphs are collections of elements which are called nodes or vertices, which are joined by edges or arcs, and in turn these edges may have a direction or orientation designated. One of the first pioneers in this field was Leonard Euler, who in 1736 posed a problem which is known as Königsberg's bridge problem, which was a Prussian city which had seven bridges. Euler raised the question of whether it was possible to go through the whole city crossing each one of the bridges just once. In a schematic representation of the city it is possible to observe that the bridges join four portions of land, which means that the search for testing and error do not lead to any result; for this reason, if this problem can be represented by a graph, it is possible to apply techniques, methods and algorithms of graph theory to find the solution. Due to this problem, the first step was taken towards graph theory, which has evolved over time and where there are numerous research groups, working in areas or fields of this discipline. Some years later, the Irish mathematician, physicist and astronomer, William Rowan Hamilton posed one of the most complex problems that exist in graph theory, the Hamiltonian path problem or the problem of the traveling salesman that consists of having a path or graph where each vertex is visited exactly once. Due to its complexity, this problem is considered in computing as a NP-Complete problem. At this point it is necessary to indicate that mathematical or computing problems are classified by their complexity in different groups:

- P complexity, where problems can be resolved by a deterministic machine in polynomial time.
- NP Complexity, where problems can be resolved in a non-deterministic machine in polynomial time.
- NP-Complete Complexity, which are problems of NP complexity which are difficult to resolve in polynomial times, with a non-deterministic machine.

There are also parallel implementations to resolve the Hamiltonian path problem but they need a great volume of resources and communications between the connected nodes. For that motive, Adleman presented a new alternative for programming with organic "DNA" which has a massive parallelism in the performance of operations and, therefore, in obtaining the end results, but with said limitations. He designed a system to resolve the Hamiltonian path problem with organic "DNA" programming and, therefore, he demonstrated that it was possible to resolve NP-Complete problems in a computational time close to the polynomial.

In this sense, we can cite patent document US7167847.

In the twentieth century, the scientist Edsger Dijkstra, suggested new systems for route calculation, so that not only did it establish how one should go from ,one point to another, but it also established that it was done in the least possible time. Dijkstra based his research on computing science, and a result of this was Dijkstra's algorithm. This algorithm is based on determining the shortest path, given a source vertex in a directed graph and with positive weights on the edges. The idea is to explore all the shortest paths which emerge from the source vertex and which arrive at all other vertices. Once the shortest path has been determined from the source vertex to the other vertices which compose the graph, the algorithm stops. This algorithm is based on a strategy, known as voracious algorithm, which does not work with graphs with negative cost edges. Later, Robert W. Floyd, together with Wharshall, modified Dijkstra's algorithm; although the modifications were relevant, they still could not be applied in industrial networks or in route calculation. Seeing the problems of one and the advantages of the other's science, the invention establishes a technology that combines electronics and genetics, two disjointed areas until now. This technology is based on integrated circuits, electronics and, "DNA" or genetics, creating with it the first inorganic "DNA" with electronic circuits, the reason for which the invention has called this technology InChroSil (Inorganic CHROmosome based in SiLicon).

The system of the invention has the great advantage that it can be reused, since the user can use it as many times as he/she likes, since it is materialized by electronic circuits.

## DESCRIPTION OF THE INVENTION

To resolve the drawbacks and achieve the aforementioned objectives, the invention has developed a new system which achieves the production of an inorganic "DNA".

To understand the invention, it is necessary to make a genetic introduction of chromosomes, which are formed by "DNA" and proteins. In turn, "DNA" is composed of two longitudinal fibres joined by centromere. These fibres are called chromatids and represent two identical strands of the duplicated "DNA".

Therefore, "DNA" is composed of strands or chains of nucleotides, which are differentiated in four types which are listed below:

- Adenine, is represented by letter A.
- Guanine, is represented by letter G.
- Cytosine, is represented by letter C.
- Thymine, is represented by letter T.

Consequently, "DNA" is composed of two linked strands and each strand contains innumerable nucleotides. There are no complementary nucleotides on the same strand, i.e. they can join without any restriction. However, on linking the two strands, there are restrictions of complementarity, so that an Adenine (A) of a single strand can only join with Thymines (T) of the complementary strand, in the same way as Guanines (G) can only link with Cytosines (C).

The system of the invention is characterized in that it comprises means of binary encoding of the four different types of nucleotides which compose the strands, so that the nucleotides which form complementary linkages are assigned complementary codes by the inversion of one of them. Furthermore, the invention includes storage units of a nucleotide code and a code selected from its complementary code or no code; all to produce a nucleotide and its complement or only a nucleotide, connecting said storage units in series to form the chain of nucleotides which constitute each strand of a "DNA" chain. Consequently, using said encoding, which is stored in the storage units, an electronic structure is produced which permits access to a nucleotide and/or to its complement, to one strand and to the two strands of the "DNA" chain as required, by known electronic circuits which make the selection of the different storage units in accordance with the desired results.

The invention provides different modules which are constituted by groupings of storage units, wherein a "DNA" chain is stored in each module, the modules being connected in rows and columns, so that it is possible to access each "DNA" chain by the selection of rows or columns.

From the description made, it is deduced that the first application of the invention consists of its use as a "DNA" database.

In the preferred embodiment of the invention the code assigned to each nucleotide comprises two bits and its storage depends on the inputs applied to each storage unit by electronic means, so that each storage unit cab be encoded according to the nucleotide desired and its complement.

The invention provides the incorporation of means of encoding of numeration at base 4 composed of four nucleotides of a chromosome (A, G, C and T).

Furthermore, it provides that the two bits corresponding to each nucleotide acquire the decimal quantities of 0 to 3 so that it permits forming a plurality of numerical presentations determined by the position of the two bits and by the value each position receives. This encoding permits that any encoding system which has correspondence with the decimal or binary can be encoded with the numeration and encoding system of the invention.

The encoding commented permits that the invention incorporates means for performing operations such as additions, subtractions, multiplications and/or divisions, as well as encoding any single and double-precision fixed or floating point number using encoding in complement A1 and in complement A2.

As with the memories of the state of the art, the storage units of the invention may be volatile, but in this case the invention calls them InChroSil Access Memory (IAM), read-only non-volatile memories also being possible that the invention calls InChrosil Read Only Memory (IROM). The invention incorporates structured means of access to the modules and storage units by localization of a "DNA" chain, subsequent localization of a strand and then by the designation of a nucleotide or group of nucleotides, so that it is possible to access the whole chain or part of it. Consequently, using the modules and storage units of the invention it is not accessed by rows or columns as occurs with conventional memories, but it permits three different accesses, as has been commented, which permits access from three selections which may be called three-dimensional access.

Furthermore, as was already commented, a "DNA" chain can be considered a row or a column, i.e. the system which administers the IAM memory can stipulate how the "DNA" chains will be stored in the memory, whether by rows or by columns.

Based on the whole structure described, it is understood that the invention may incorporate means for encoding in the storage units, which form strands, representations of problems by graphs which comprise elements constituted by vertices and edges and they may optionally incorporate the weight or direction of the edge, so that the system of the invention encodes a strand in a first set which contains vertices and edges and does not contain the weight thereof, corresponding to initial elements which do not contain final elements: having provided that a second set is encode on the complementary strand, which contains elements of the graph equally constituted by vertices and edges corresponding to the final elements and those corresponding to the elements which do not contain final elements. Each one of the storage units of both strands are interconnected by comparers which form a matrix so that the processing of both strands is performed in parallel as well as the comparisons between all the elements of both sets, which permits resolving problems which may be represented by graphs.

The comparers form a matrix and are connected to a buffer whereto means of recovery of polynomial order are applied to determine the most optimum route between two points of the graph.

As was indicated, the edges of the graphs may have weight or direction, in which case the invention comprises additional storage means for the weight of an edge, as well as means to add the weights of each edge and obtain the total weights of each edge, having provided that it incorporates means of sorting the total weights of each edge according to previously established criteria, which permits resolving algorithm problems such as those of Dijkstra, Floyd-Warshall and Bellman-Fvrd, Ford-Fulkenson.

The structure described permits its application in flow problems, which may be vehicle fleets, optimization of industrial processes, work flows, coupling problems and communications networks, for which these problems are represented as a graph. Thus, for example, the information and instruction of the machinery of an industrial plant can be represented as a graph to resolve the problem posed.

Likewise, the invention provides encoding the Hamiltonian path problem in the memory units which constitute the strands, in one of which is encoded the complete graph with known restrictions. In this case, the strands are connected to comparers forming a matrix to compare the edges of both graphs two by two in parallel form to indicate if the bits of the result of each comparison are all the same and they refer to the same edge and, in consequence, this belongs to both graphs.

Means are applied to the result of the comparison to create levels of Wallace tree indicative of whether the edge is path or not, so that the Hamiltonian path problem is resolved.

In this case, the comparers which compare the edges of both graphs two by two, are constituted by logical carry-free half-adders, whose output is connected to a logical port of detection of a single bit of the comparison result, to obtain a single datum, as was Indicated, and which indicates if the bits of the result of each comparison belong to both graphs of the encoded sets.

The means to create Wallace tree levels comprise first logical ports for each column of the matrix of comparers, which represents the complete graph and are connected to the outputs of the comparers to confirm the belonging of said edge to the set of edges of the graph with restrictions so that it indicates whether it is path or not.

The outputs of the first logical ports are connected to a second logical port which detects if all the edges are path, so that the invention determines the Hamiltonian path. Furthermore, it incorporates storage means of the result obtained.

In this case, the invention also provides the possibility that the weight of the edges is taken into account, for which reason it comprises means to receive the paths found and establish the correspondence between weight and edge and obtain the weights of each path. In this case it also comprises means of sorting of the weights of the paths according to previously established criteria for the choice of the best path.

In another embodiment of the invention, when the vertices are encoded and, therefore, the value of the edges which connect them established, the system stores in that memory address, the value of the weight of that edge in the graph. In this case, it seeks the value of the edges in the memory, since as its address is known, its value is known, i.e. it encodes a reference to the memory, which is its address and not the value of the edge. The weights obtained are added to obtain the totals of each path which are stored in the memories with addresses and by means of sorting the weights of the paths according to previously established criteria, the choice of the best path is carried out.

This configuration also permits the application of the invention to solving Hamiltonian cycle problems by an indicative encoding that the output vertex of the graph is equal to the destination vertex.

It should also be indicated that the invention incorporates means for encoding a graph so that the vertices represent the edges and vice-versa and thus obtain what sequence of vertices should be followed to pass through all the edges and permit resolving the Eulerian path problem.

By incorporating means for encoding on the strands that the initial vertex is the same as the final vertex, it permits the application of the invention of the cycle to solve Eulerian cycles.

The invention also permits establishing encoding of the weight of the edges in the resolution of Eulerian paths or cycles, so that it permits suggesting new optimization problems of Eulerian paths.

Below, to help towards a better understanding of this specification and forming an integral part thereof, a series of figures is attached, wherein with illustrative and non-limitative character, the object of the invention has been represented.

## BRIEF DESCRIPTION OF THE FIGURES

**Figure 1.-** Shows a representation of the organic "DNA" chain.

**Figure 2**.- Shows the different types of "DNA" chain structures and the linkages between nucleotides.

**Figure 3.-** Shows a possible example of embodiment of an implementation of a storage unit of a nucleotide and of its complement

**Figure 4.-** Shows a table of the correspondence between different numeration systems compared with the encoding a base 4 of the invention.

**Figure 5.-** Shows a table corresponding to the addition operation of two nucleotides according to the encoding of the invention.

**Figure 6.-** Shows a table equivalent to the previous figure, but for subtraction.

**Figure 7.-** Shows a representation of a possible example of subtraction.

**Figure 8.-** Shows a table equivalent to figures 5 and 6, but for multiplication.

**Figure 9.-** Shows a possible example of a multiplication.

Figure **10.-** Shows a table representing a single-precision floating point according to the encoding of the invention.

**Figure 11.-** Shows a table of different combinations of the exponent (as fixed, complement A1, A2 and excess $4^4$).

**Figure 12.-** Shows a table of representation of double-precision floating point.

**Figure 13.-** Shows a schematic representation of the basic storage unit represented in figure 3.

**Figure 14.-** Shows a schematic representation equivalent to the previous figure, but according to a more detailed configuration.

**Figure 15.-** Shows a representation of the structure of a possible grouping of volatile and non-volatile memories represented in figures 13 and 14.

**Figure 16.-** Shows a representation of a possible example of a graph.

**Figure 17.-** Shows a possible implementation for the calculation of paths.

**Figure 18.-** Shows a representation of a Hamiltonian graph, directed and non-weighted.

**Figure 19.-** Shows a representation of the graph of the Hamiltonian path.

**Figure 20.-** Shows an inorganic "DNA" chain of the invention referring to a possible grouping of edges and vertices to resolve the Hamiltonian path problem.

**Figure 21.**- Shows an encoding of the vertices and edges according to the previous figure.

**Figure 22.-** Shows a detailed encoding of the vertices and edges of the previous figure.

**Figure 23**.- Shows the set of Inorganic "DNA" chains of the invention with all the possible path solutions.

**Figure 24.-** Shows the representation of a logical half-adder which is applied to the system of the invention.

**Figure 25.-** Shows a representation of a possible implementation to make the comparison of edges in parallel for the resolution of the Hamiltonian problem.

**Figure 26.**- Shows a functional block diagram of the implementation of the invention for the resolution of Hamiltonian problems.

**Figure 27.**- Shows the complete circuit for the solution of the Hamiltonian path.

**Figure 28.**- Shows a functional block diagram of a first implementation for the resolution of the weighted Hamiltonian path problem.

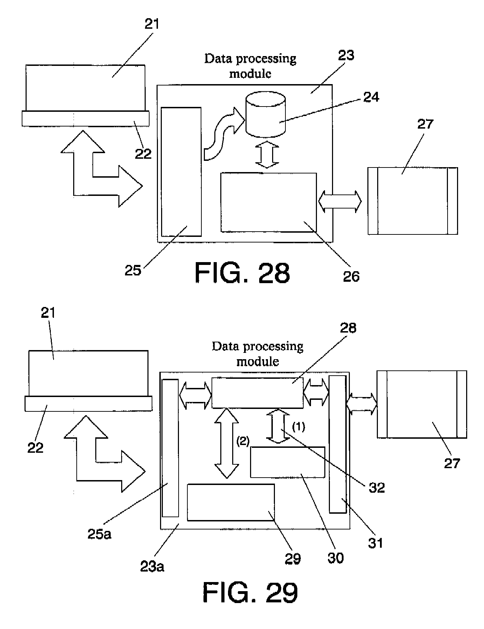

**Figure 28.-** Shows a functional block diagram of a second implementation for the solution of the weighted Hamiltonian path problem.

## DESCRIPTION OF THE PREFERRED EMBODIMENTS

Below, a description is made of the invention based on the aforementioned figures.

As has already previously been commented, a chromosome is formed by "DNA" and proteins. In turn, "DNA" is composed of strands or chains of nucleotides, which are differentiated in four types: Adenine (A), Guanine (G), Cytosine (C) and Thymine (T).

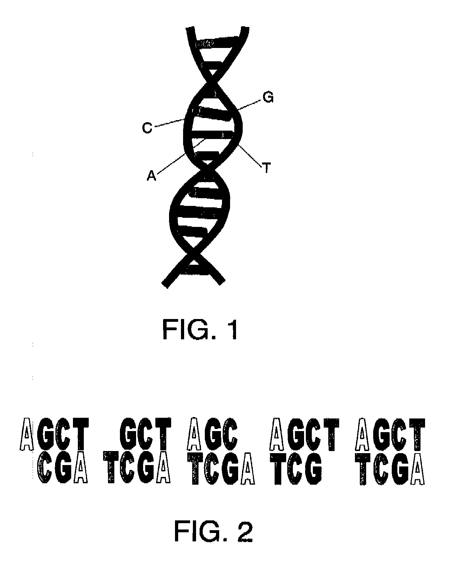

"DNA" is composed of two linked strands and each strand contains innumerable nucleotides. There are no complementary nucleotides on the same strand, i.e. they can link without any restrictions. Instead, on linking the two strands, there are restrictions of complementarity, so that an Adenine (A) of a single strand can only link with Thymines (T) of the complementary strand, the same as for Guanines (G) with Cytosines (C), is another possible linkage. Due to this organization of the strands, the DNA encoding cannot be random and it should have a previously defined structure (see figure 1).

An encoding is designed to model the organic behaviour of the chromosome, which is described in detail In later sections, for each one of the nucleotides; in the following enumeration part of this encoding is presented:

- Adenine (A) is assigned the value of "00".
- Guanine (G) is assigned the value of "01
- Cytosine(C) is assigned the value of "10".
- Thymine (T) is assigned the value of "11".

Once the nucleotides are encoded, following the implemented encoding, the next step is the implementation on a physical level by electronic circuits (for example, bistable or another device that stores the nucleotides or states), and establishing the physical structure thereof within the strands and their relations with the complementary strand within the strands and their relations with the complementary strands. The idea that was initially suggested was a circuit, which was divided in four equal parts. Each part of the circuit was separated from the other by an insulating material so as to not cause interference among the different components which are stored therein. On the other hand, in each part of the circuit would be placed the components which encode a certain inorganic nucleotide. This would permit the free choice of a determined nucleotide within the position of an artificial strand by the connections permitted between the different nucleotides.

The length of the strand will depend on the number of circuits placed in the form of a stack, thus creating a three-dimensional chip, something that would permit the emulation of the organic structure (chromosome). It can also be performed, at a planar level: the choice of one technology of another would depend on the existing resources and the final needs of the project.

Once the circuit is encoded with the four nucleotides, each circuit must be connected with its upper circuit, by connections in series, in this way a strand or chain of nucleotides is produced. On the other hand, connections in parallel or links with the complementary strand were thought of; it is necessary to bear in mind the relations of complementarity of the different nucleotides, a relation previously explained. These linkages were encoded within the circuit by logical components.

This system will define the nucleotide of a strand and with the combinational circuit or inversion method, the complementary nucleotide on the other strand would immediately be obtained. If this is applied in each stacked circuit, a chain reaction would occur, which would permit defining the complete strand. This would avoid inconsistencies between the parallel linkages, since two nucleotides which are not complementary cannot be linked.

On the other hand, the linkages in series or between nucleotides of a same strand will be performed by specific position, i.e. it will be performed adjacently, which means both sequential and random access can be made to a certain strand. With this access system, and the parallel connections, a certain pair of nucleotides can be activated at any time and innumerable combinations and different chromosomes can be achieved.

This initial approach wastes much information on each operation, since there are parts of the circuit which are not used, only making use of half of the circuit, i.e. the initial approach was to make a circuit with the four nucleotides in static form, in this way if a determined nucleotide was chosen, the nucleotide of the complementary strand was activated on the same circuit. It should be indicated that in this initial approach the nucleotides of a same level reside in the same circuit and they are activated by the activation of one of the two. For that reason, if a pair of nucleotides is configured, half of the circuit resources are wasted, for that reason a more dynamic approach was devised, where the nucleotides were not predefined in the circuit and that depending on determined inputs we would obtained one determined nucleotide or another.

With this new approach the nucleotides in a circuit become two and, in addition to being dynamic, i.e. depending on determined inputs, a determined type of nucleotide is produced. This reduction means that the circuit resources are better used, since it goes from a four-part circuit to a two-part circuit. This entire simplification will not affect the nucleotide structure, since it will continue being composed of two bistables or equivalent electronic components, although the value stored in them will depend on the inputs applied, since they must be dynamic.

With this new design, it goes from a stack structure to a totally helicoidal structure as is seen in figure 1. Therefore, this approach simplifies the circuit and the use thereof, furthermore, in the manufacturing phase there is a considerable reduction in production costs and the use of digital and electronic resources, on better using the space and the components.

The inorganic connections of the chromosome are divided in two very important parts: connection in series, where a determined nucleotide can connect with another nucleotide of the same type or another and, on the other hand, parallel connections where a determined nucleotide of a strand can only be connected with its complement or none. Therefore, if the strand has all its connections or linkages, it is said that the strand is complete, whilst if one of the nucleotides does not have correspondence with its complement, the strand is incomplete, This characteristic was taken into consideration when designing the parallel connections between nucleotides of complementary strands, since in the activation of one of the nucleotides it indicates thereto if the activation of the complementary nucleotide will take place. With this proceeding, any chromosome structure is emulated, since not all have the same characteristics and all the pairs of nucleotides.

To explain the possible combinations of DNA chains, figure 2 shows the combinations that may arise. These structures make it possible to perform operations with the DNA chains, so that complex problems can be performed, such as NP or NP-Complete. As has been commented, the invention is based on the relation existing between the nucleotide pair and all its possible linkages between nucleotides of the same strand, and between nucleotides of complementary strands.

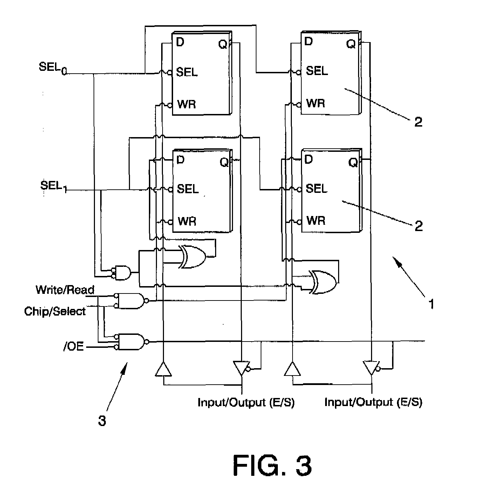

Figure 3 represents an example of implementation which is adjusted to the aforementioned description and wherein a storage unit 1 is materialized by four bistables 2 of type D, so that the two upper ones are provided for the encoding of a nucleotide and the two lower ones for the encoding of its complement.

For example, let us suppose an implementation as in figure 3, if we only want to use the top nucleotide (incomplete strand) the SEL0 signal of figure 3 will be activated, in this way the input/output (I/O) signal allows us to establish the value that is desired to store the bistables **2** of the top nucleotide, Instead, if only the top nucleotide is activated the SEL1 signal of figure 3 and, in the same way the (I/O) signal, will permit establishing the value of the bistables of the bottom nucleotide.

In contrast, if it is desired that the two nucleotides are activated (complete strand) the SEL0 and SEL1 signals are activated and, by the (I/O) signals, the value of one of the nucleotides is established, whilst the other nucleotide will be activated with the use of XOR ports. With this design of a pair of nucleotides it is possible to achieve all possible combinations between nucleotides of complementary strands and, therefore, emulate the behaviour of the possible combinations of an organic chromosome.

The logical ports of the storage unit **1** permit encoding the linkages within the actual circuit, we well as establishing their value by the write/read signal (W/R).

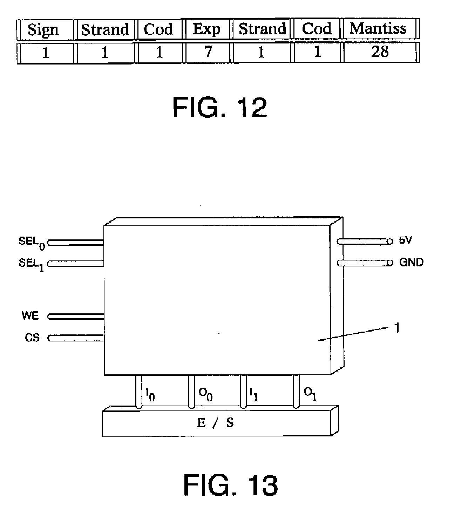

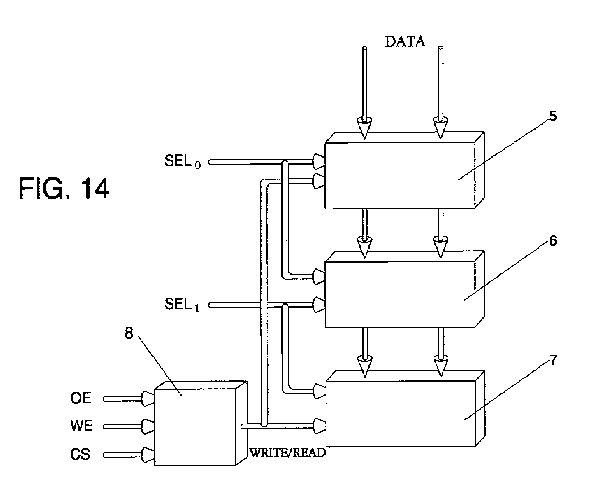

The schematic representation of this storage unit **1** is shown in figure 13 and 14 as will be described later.

It also provides for the encoding of a numeration system at base 4, which is composed of two nucleotides which form a "DNA" strand. This new system is called Cod-InChraSil (CODification - Inorganic CHROmosome based in SiLicon) in the invention, so that it provides the possibility of increasing the accuracy of the current numerical systems, in addition to being able to use the intrinsic characteristics of a DNA strand in the operations.

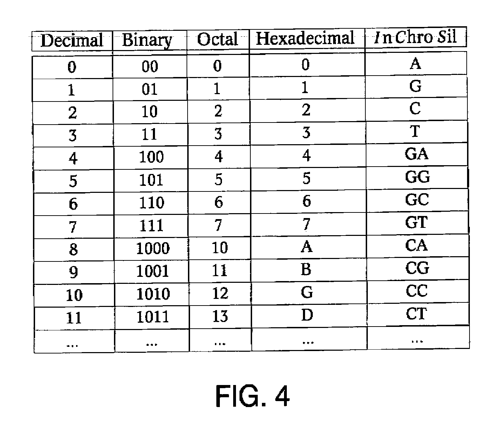

The numeration system at base 4 of the invention uses the nucleotides of a "DNA" strand A, G, C and T as symbol. Conventionally, the encoding of organic "DNA" is known macroscopically, whether by encoding a strand or portion, or also encoding the operations with its operands. These encodings do not permit as much flexibility because they limit the number of combinations that can be performed. For that reason, the invention consists of a numeration system where the DNA is encoded microscopically, i.e. at a nucleotide level which forms the DNA strand. This characteristic of atomicity permits performing combinations to generate a numeration system which has a potency and scalability, necessary for the representation of numerical quantities. The encoding of a nucleotide is defined as a two bit sequence, which acquire the decimal quantities of 0 to 3. This numeration system we present makes it possible to form numerous numerical representations, formed by the position and value of the symbol within the numerical chain, to highlight that this numerical system is positional and that the symbol has two meanings, on the one hand the position within the numerical chain and, on the other hand, the value the symbol receives. With the combination of both pieces of information, it is possible to produce part of the final value of the numerical quantity which one wants to represent. Figure 4 shows the correspondence between our numeration system of the invention and the other numeration systems that are currently being used.

An example is always more clarifying than a set of words, for that reason, if we consider number $4567_{10}$ in decimal base, the corresponding binary representation is $0001000111010111_2$, in octal is $010727_8$, in hexadecimal is $11D7_{16}$ and finally, in the *Cod-InChroSil* encoding it is $AGAGTGGT_4$. It is also possible to change from a numerical system using a polynomial development of the number (fundamental theorem of the numeration), where the figures of the number have two values, on the one hand the intrinsic as figure and then the positional, in this way the change equation is determined as follows:

$$n^o\ (X_{n-1}....X_2X_1X_0)_b = X_{n-1}b^{n-1}+.....+X_2b^2+X_1b^1+X_0b^0$$

For example, we have the following number encoded in *Cod-InChroSil* $AGAGTGGT_4$, the decimal number is the following:

$$AGAGTGGT_4 = A\cdot4^7 + G\cdot4^6 + A\cdot4^5 + G\cdot4^4 + T\cdot4^3 + G\cdot4^2 + G\cdot4^1 + T\cdot4^0 = 0\cdot4^7 +$$
$$1\cdot4^6 + 0\cdot4^5 + 1\cdot4^4 + 3\cdot4^3 + 1\cdot4^2 + 1\cdot4^1 + 3\cdot4^0 = 4567_{10}$$

The inverse operation of a decimal number to a *Cod-InChroSil* encoding. Supposing the decimal number to be $189_{10}$, the *Cod-InChroSil* number is as follows:

$$189 \text{ div } 4 = 47 \rightarrow \text{minus}(189.4) = 1 \rightarrow G$$

$$47 \text{ div } 4 = 11 \rightarrow \text{minus}(47.4) = 3 \rightarrow T$$

$$11 \text{ div } 4 = 2 \rightarrow \text{minus}(11.4) = 3 \rightarrow T$$

$$2 \text{ div } 4 = 2 \rightarrow \text{minus}(2.4) = 2 \rightarrow C$$

$$189_{10} = CTTG_4$$

Examples are shown; let us suppose we have number $873.875_{10}$ and we want to change to *Cod-InChroSil*, the mechanics is as follows:

- The integer is calculated as in the previous example TGCCG.
- $0.875 \times 4 = 3.5 \rightarrow$ the Integer is 3 so is T.
- $0.5 \times 4 = 2 \rightarrow$ the integer is 2 so is C.
- Finally, the decimal part is zero, so the end number is $TGCCG,TC_4$

In general terms, in a numeration system it is possible to represent the numerical quantity in the following way $N_b [a_{n-1} a_{n-2} a_{n-3}... a_3 a_2 a_1 a_0, a_{-1} a_{-2} a_{-3} ...a_k]_b$, where n+k indicates the quantity of digits of the figure; in turn, n indicates the digit number in the integer, whilst k indicates the fraction. Finally, it should be indicated that the use of the *Cod-InChroSil* numeration system is compatible with current numeration systems; proof of this is found in the previous paragraphs, which has gone from decimal to *God-InChroSil* and to *Cod-InChroSil* to decimal.

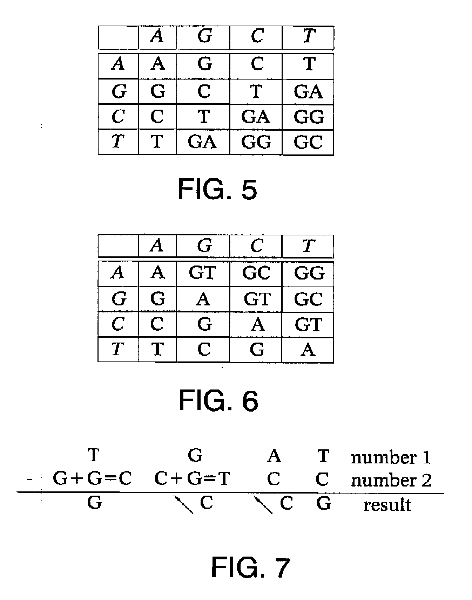

All numeration systems need rules and operations to be able to make calculations between its operands. For that reason, in *Cod-InChroSil*, it considers the normal ones which are: addition, subtraction, multiplication, division, etc. In first place, addition is defined, due to the fact that it is an operation highly used in numerous mathematical calculations. Addition is an arithmetic operation defined on a set of numbers and its structures (vectors, sets, etc.). In the invention, addition is defined as an operation on numbers encoded in *Cod-InChroSil*. As is well known, addition has different properties that are characterized and will be applicable in the invention, these are: stitching property, where the order of the operands does not change the result, associative property, neutral element and, finally, opposite element. Figure 5 gives the guidelines for the addition of two nucleotides. We should highlight, that as in the decimal addition, which when the base is surpassed we say the phrase *and carry one*, in this adding operation the carry caused by the overflow is also taken into account, which we can observe in figure 5 where there are cells of the table which have two symbols, the first of them represents the overflow produced and, the second the result of the operation, i.e. supposing that we want to add two numbers ATCGATA and TAGCCAA, in this case no carry is produced.

```
              Count or carry
    ATCGATA    number 1 (3660 in decimal)
  + TAGCCAA    number 2 (12704 in decimal)
  ---------------------------------------------
    TTTTCTA    result (16364 in decimal)
```

In this other example we have the following numbers ATCGATA and ATCTTTC, in this case carries do occur.

```
G G G G G    count or carry
A T C G A T A   number 1 (3660 in decimal)
+ A T C T T T C  number 2 (3838 in decimal)
---------------------------------------------
G ↑T ↑G ↑G ↑A ↑CC  result (7498 in decimal or GTGGACC)
```

The following operation which is defined is subtraction in *Cod-InChroSil* encoding. Subtraction is known as an arithmetic operation opposite to addition, in the particular case of the invention, subtraction between two nucleotides is defined following the guidelines of figure 6 below.

As is observed in figure 6, the carry caused on subtracting two nucleotides has been taken into consideration, for that motive and as was done with the addition operation, in the same cell of the table (see figure 6), two symbols are written, the first makes reference to the overflow or carry and the second makes reference to the result. To see how the subtraction functions by this encoding, a clarifying example is shown of this operation. The following numbers in *Cod-In-ChroSil*, $TGAT_4$ (in decimal 211) and $GCCC_4$ (in decimal 106), the result of the subtraction is 105 in decimal $GCCG_4$ in *Cod-InChroSil*, then the calculation is performed with the subtraction that has been defined in figure 7.

As we observe in figure 7, when T - C = G is subtracted no carry occurs, but when A - C = GC is subtracted (the following figure of the number), the result is C, but the carry is G, this quantity has to be added to the following figure, in this case it is C. T is obtained from this addition operation. Next, G is subtracted from number 1 from the new results (T), producing the value of GC, again a carry has occurred with value G. This carry is added with the following figure of number 2 and the result is subtracted with its positional homologue of number 1, which gives G. As is observed, the mechanism is the same as in the subtraction in decimal, when the figure of number 1 is greater than the figure of number 2 subtraction is performed and overflow does not occur, but when it is the opposite, it is calculated how many we carry from the figure of number 2 towards the figure of number 1, this being the result. Next, one unit is added to the following figure and both figures are subtracted from the same position. The subtraction can also be established as the addition of two numbers, where one of them uses the opposite (in this case complement) plus the addition of nucleotide G (this representation format will be explained in later sections). As was commented in *InChroSil* the DNA chain is formed by two strands which are governed by properties of complementarity, i.e. a nucleotide of a strand cannot link with any nucleotide of the complementary strand, only with its established complement. This permits that when a number is encoded in *Cod-InChroSil* in a DNA chain, it is automatically encoding its complement in the complementary strand. This intrinsic property of DNA chains, permits applying addition operations very easily, since it already has the opposite or complement of this number, it is only necessary that this number was added by nucleotide G, representation format called 2's complement and, which in subsequent lines in this document is explained in detail. We resort again to the example, to give a more clarifying vision of the subtraction operation in this numeration system. If it has number TGCG (217 in decimal) and we want to subtract it with number CCCT (171 in decimal), the decimal subtraction gives us the following result; 46 (ACTC). The following steps are applied in this numeration system:

- The first operand is not modified (TGCG)
- The complement of the second operand is taken, i.e. A is transformed into T and vice-versa and, C is transformed into G and vice-versa, in this case in particular it is GGGA.
- G is added to the number resulting from point 2 (GGGG).
- The first operand and the number of point 3 is added.
- The maximum number of nucleotides from the two operands is chosen and this will be the result of the operation, in this example it is ACTC.

In the form of equation we would have the following form: $Resol_{Subtraction} = Operand1_4 + Complement(Operand2_1) + G_1)$, where $Resol_{Subtraction}$ is the result of the subtraction, $Operand1_4$ is the first operand in encoding Cod-*InChroSil*, $Operand2_4$ is the second operand in the same encoding as $Operand1_4$ and, finally, $G_4$ that represents the literal of nucleotide G of a DNA strand. On the other hand, it defines the complement function, as an injective function so that $\forall$ x, y $\in$ {A, G, C, T}, $\exists$ once f, complement function, so that f:{A, G, C, T} $\rightarrow$ {A, G, C, T}, where f(x) = y, x $\neq$ y, y is the complementary nucleotide of x.

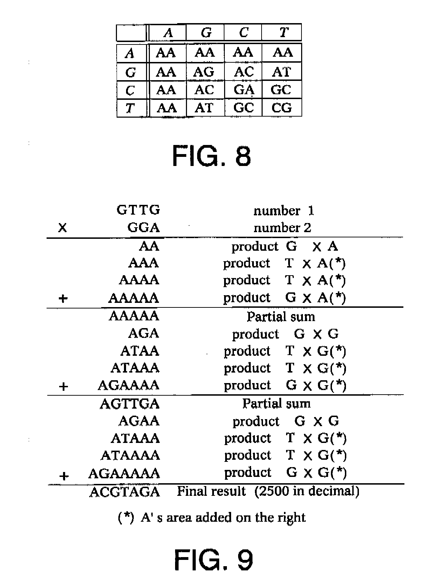

The following operation defined is multiplication. The multiplication or product is defined as an arithmetic operation where successive additions are performed. As with previous operations, guidelines are given for multiplication at a nucleotide level, these products are observed in figure 8.

We have the following numbers GTTG (125 in decimal) and GGA (20 in decimal) then the product of both is that shown in figure 9. As is observed, a product of a nucleotide is performed for the whole chain, thus generating successive additions, as happens with decimal multiplication, It should be highlighted that the previous operation has taken into account the carries in the sub-additions, although they have not been represented, the cause is the graphic overload of information in the representation of the previous product. Furthermore, it was explained in the definitions of additions, that due to the addition of two nucleotides, which cause overflow or carry, the carry quantity is added to the following nucleotide.

Finally, we still have to define the arithmetic operation of division. Division is performed the same (it has the same mechanism) as in the decimal case, but unlike that of the decimal, subtractions and multiplications are performed by subtraction and multiplication operations respectively, which have been defined in this document. For example, let us suppose the following numbers in *Cod-InChroSil*; dividing it is AGAACGA (in decimal it is 1060), whilst the divider is TGA (in decimal it is 52). After performing the operation, the quotient of the division is 20 in decimal (GGA in *Cod-InChroSil*) and, the subtraction, it is also 20 in decimal (GGA *Cod-InChroSil*), in this way, AGAACGA = TGA GCA + GCA (dividing = divider x quotient + subtraction).

Finally, it is necessary to indicate that with this numeration system, *Cod-InChroSil*, all kinds of operations can be performed as with the existing systems (binary, octal, hexadecimal, etc.). This characteristic together with the great possibility of migration to other numerical systems, permits working with the information on the DNA strands with greater ease and performing operations with them that were previously unthinkable. For that reason, the *Cod-InChroSil* numeration system, in addition to serving as support to all technology related to *InChroSil* and to this invention, is presented as an alternative for the manipulation and use of information contained in the DNA strands.

On the other hand, it should be stated that a floating point representation is a representation method of real numbers, where the peculiarity is the floating or the movement of the point, an element which separates the integer from the decimal part (fraction) of a real number. In opposition, there exists the fixed point representation system, where the number of digits which belong to the decimal part and which belong to the integer is previously established. These floating point representation systems permit the numeration systems to represent large numerical quantities. This is the cause for which this *floating point* format is widely used to represent large numbers. A clear example is found in the area of IT, where this type of representation has been used for the storage of very large numerical representations, which may then be handled mathematically. On the other hand, all floating point numbers follow an established pattern, which can be summarized in the following equation: $r = m \cdot b^e$, where **r** is the real number, m is the mantissa, **b** is the base and, finally, **e** is the exponent, which permits raising the base. For example, number $0.000123_{10}$ in fixed point (we use the decimal system), in floating point could have the following representations: $1.23 \ 10^{-4}$, $0.123 \ 10^{-3}$, $0.0123 \ 10^{-2}$, $0.00123 \ 10^{-1}$, etc. As is observed in the previous representations, all make reference to the same number but with different representation in floating point. For that reason, and to avoid ambiguities in the representations of numerical quantities, a standard was established which permits the homogenous representation of floating point numbers. This standard was presented to the IEEE last century, more specifically in the 1980s, with the standard name IEEE 745. This standard permits defining a wide range of representation formats of numerical quantities, such as zero and denormalized values (the infinite and NAN). On the other hand, a set of operations is also defined which can be performed in this format, called *Floating point arithmetic*. In this standard, the number of bits that can be used is related with the accuracy that can be obtained with the representation of the numbers, i.e. if they use more bits, the accuracy and the range of representation is greater. This permits differentiating two large groups, although extensions of both exist in the literature, The first of them is that of simple accuracy, which uses 32 bits for its representation. These 32 bits are distributed in three sections which identify the number. On the other hand, we have another format of the standard, which presents greater capacity in its representation and which is composed of 64 bits, the double, thus its name double precision. As with its little brother, the bits in this format are distributed among 3 sections or fields, which characterize and identify the number. In the following lines we will explain the floating point system for the *Cod-InChroSil* numeration system. As was previously stated, it is a numeration system which allows representing numerical quantities with only four symbols, the nucleotides which compose a DNA strand. But as with current numeration systems, many symbols are needed to represent large numerical quantities. As previously observed, the flexibility of floating point formats is very important, for that reason, it has been considered to establish a floating point format which permits representing very large numbers by encoding in Cod-InChroSil. If we use this encoding in the *InChroSil* systems, we find that on the one hand there is the possibility of representing very large numbers, and, on the other and the information on this number stored is increased, since when a number is represented in the format, it is also storing the number complimentary or opposite to it. This permits largely simplifying the mathematical operations that both numbers need. The following step is How can the format be established to be able to use this characteristic offered by the *InChroSil* systems and, in short, the DNA?, the response is found in the following lines, which explain how a floating point representation format has been defined for numbers encoded in *Cod-InChroSil*. The invention can define two large precisions for floating point representations; on the one hand, there is the single precision format, which has been defined as having 20 nucleotides in its representation, making a small aside in this part of the document, as the reader has well perceived in the previous lines, we are not speaking of quantifying the length of the representation, of bits, but, of nucleotides. Continuing with the explanation of the format, 20 nucleotides have been used to establish the single precision format. In this format, the 20 nucleotides are shared or distributed in 6 sections or fields, which are described below; two sections of the six are devoted to establishing which of the two strands is used to represent or define the exponent and the mantissa respectively.

Different sections have a nucleotide length, sufficient information to be able to decide what part should be chosen. For example, if we find a representation where nucleotide A appears in a section before the exponent, it indicates that the exponent which is needed is in the upper strand, In contrast, if a T nucleotide is found, it indicates that the exponent is represented by the lower strand. With this set of positions, various combinations can be performed in the representation of the same number and largely simplifying possible mathematical operations. There are another two sections within the floating point representation format, which have the function of specifying the type of encoding which is represented with the exponent and the mantissa. Four types of encoding can be considered for this format, which are those which are presented in the following enumeration.

- Magnitude Sign (takes the value of A in the section): The representation format of integers with sign which is called Magnitude Sign, which imitates our manual writing of whole numbers, on the one part the sign and then the magnitude of the number, For example, number $-34_{10}$ which in *Cod-InChroSi*l is $GAAC_4$, if it is considered that the negative sign is encoded as C and, in contrast, the positive sign by A, therefore the number of our example is the following CGAAC.
- One's complement (takes the value of G in the section): It defines one's complement with the following equation $N_b{}^{Ca1} = b^n - N_b$, where $N_b{}^{ca1}$ is the number in one's complement of the number if $N_b$ is $N_4 = CCTAAAG$ then its one's complement is $N_4{}^{ca1} = 4^7 - CCTAAAG = GAAAAAAA - CCTAAAG = GGATTTC$.
- Two's complement (takes the value of C in the section): Once one's complement is calculated, it is easy to obtain two's complement, therefore the calculation of the two's complement would be by the following equation $N_b{}^{Ca2} = b^n - N_b + 1$, therefore following the previous example, the number in two's complement is the following $N_4{}^{Ca2} = 4^7 - N_4 + G = GAAAAAAA - CCTAAAG + G = GGATTTT$.
- Excess N (takes the value of T): The excess n is formula of the following form $N^{Exess}{}_4 = N_4 + (N-1)$.

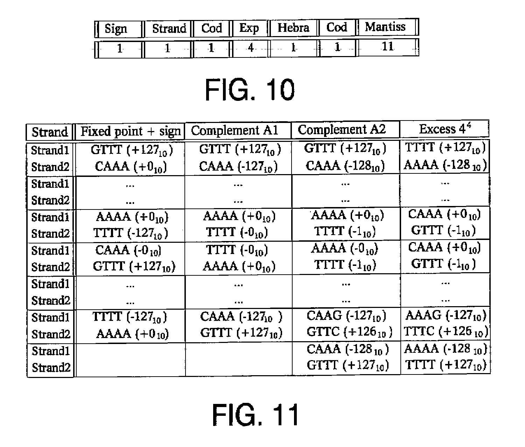

In short, these sections specify the encoding where the element is (exponent or mantissa respectively), i.e. if the nucleotide before the exponent or the mantissa has, for example, the value of G, this indicates that the exponent or mantissa is encoded in complement A1. Finally, It should be indicated that the length of these sections is of a nucleotide, the same as with the sections that determine the strand to use. To be able to conclude the explanation of the sections which form the single-precision floating point format, it refers to the sign section with a length of one nucleotide and which permits knowing the sign of the number that it represents, i.e. if in this section we have nucleotide A, it means that the number is positive, in contrast if it has nucleotide T the number is negative. Furthermore, there is the section of the exponent, which has a length of 4 nucleotides. Finally, there is the section of the mantissa which, with a length of 11 nucleotides, completes the 20 nucleotides which form the representation format. In general and graphically, figure 10 shows the different sections in which the single-precision floating point format with 20 nucleotides is divided.

With the previous format, exponents can be achieved with the following ranges of values, which are presented in the following enumeration.

- Fixed point with sign, if x is the exponent then $x \in [-127, 0] \cup [0, +127]$
- Complement A1, if x is the exponent then $x \in [-127, 0] \cup [0, +127]$
- Complement A2, if x is the exponent then $x \in [-128, 0] \cup [0, +128)$
- Excess 4°, if x is the exponent then $x \in [-128, 0] \cup [0, +128)$

Figure 11 shows the different encodings that the exponent can take on, The different relations thereof can also be observed in different encoding systems, in addition to the double strand characteristic which can be used according to the operations or purpose agreed.

On the other hand, the mantissa is taken to be composed of 11 nucleotides, in this way the ranges that can be obtained with the following codifications are the following:

- Fixed point without sign, If m Is the mantissa then $m \in [-4^{11}-1, 0] \cup [0, 4^{11}-1]$
- Complement A1, If m is the mantissa then $m \in [-4^{11}-1, 0] \cup [0, 4^{11}-1]$
- Complement A2, If m is the mantissa then $m \in [-4^{11}, 0] \cup [0, 4^{11})$
- Excess $4^{11}$. If m is the mantissa then $m \in [-4", 0] \cup [0, 4^{11})$

Overall, numbers can be achieved with this single-precision floating point representation format which are included in the following number range $[-l\ 7592186044416 - 10^{127}, 0] \cup [0, 17592186044416 \cdot 10^{127}]$, We will complete the explanation of the single-precision format with an example which has already been used for the IEEE 745 format. Remembering that the number was $-118,625_{10}$ and its encoding in IEEE 745 of single precision is 11000010111011010100000000000000, a 32-bit binary number. Therefore, using our single-precision floating point system of the invention, we get the following encoding.

Strand 1: T AT CAGG AA AGCCCAAAAAA
Strand 2: A TA GTCC TT TCGGGTTTTTT

As can be observed, the first number is negative, for that reason the first nucleotide has been encoded as T, the following nucleotides indicate that the exponent is represented in strand 1 and its encoding is excess 128. With respect to the mantissa, it is represented with fixed point without sign and it corresponds to strand 1.

The following floating point representation format is double precision, which used 40 nucleotides or two strands of 20 nucleotides, The double-precision representation format is the same as that for single, with the exception that the number of nucleotides is increased in the exponent and mantissa sections. Figure 12 graphically shows the double-precision representation format for 40 nucleotides.

The range of values which the exponent may allow would be defined by the following enumeration.

- Fixed point with sign, If x is the exponent then $x \in [-4^7-1, 0] \cup [0, 4^7-1]$
- Complement A1, If x is the exponent then $x \in [-4^7-1, 0] \cup [0, 4^7-1]$
- Complement A2, If x is the exponent then $x \in [-4^7, 0] \cup [0, 4^7)$
- Excess $4^7$, If x is the exponent then $x \in [-4^7, 0] \cup [0, 4^7)$

For the case of the mantissa, the range of values that can be represented in this double-precision floating point format are those shown in the following enumeration.

- Fixed point without sign, If m is the mantissa then $m \in [-4^{28}-1, 0] \cup [0, 4^{28}-1]$
- Complement A1, If m is the mantissa then $m \in [-4^{28}-1, 0] \cup [0, 4^{28}-1]$
- Complement A2, If m is the mantissa then $m \in [-4^{28}, 0] \cup [0, 4^{28})$
- Excess $4^{28}$, If m is the mantissa then $m \in [-4^{28}, 0] \cup [0, 4^{28})$

By making different combinations between the exponent and the mantissa, it is possible to obtain numbers with this double-precision floating point format which would be included In this numerical range $\in [-72057594037927936 \cdot 10^{65536}, 0] \cup [0, 72057594037927936 \cdot 10^{65536}]$.

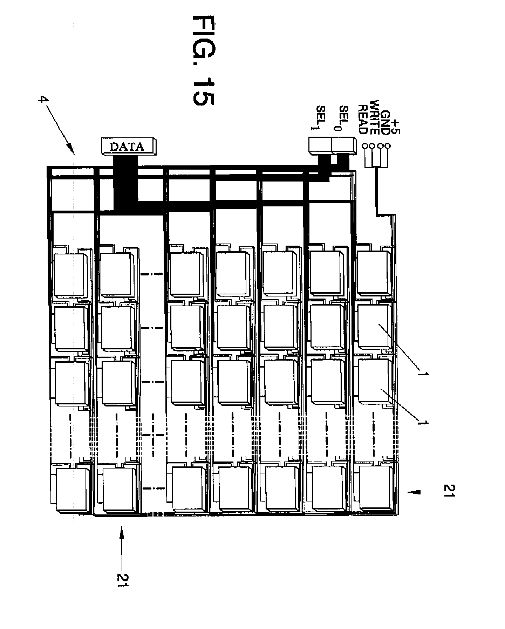

The storage unit 1 described may be of two types that the invention has called *Mom-InChroSil* (Memory INorganic CHROmosome based in SILicon). The invention may use volatile and non-volatile memories. The volatile memory implemented has been called *InChroSil* Access Memory (IAM). This type of memory, In addition to having the characteristic of being volatile, has the property of structured access; in this way we access a nucleotide, by the previous localization of the strand, to later designate the nucleotide. The volatile memory of the invention permits the writing and reading of the information stored in it. This memory is volatile, i.e. If it Is disconnected from the electrical energy, the information is lost. For this reason, this type of temporary memory is usually used to store intermediate results or data which are not permanent The access designed for this type of memory is structured, i.e. if we want to obtain data of this memory, the functionality is the following: an inorganic DNA chain (or also called *InChroSil*) of the memory is chosen. Once the inorganic DNA chain has been determined, the strand Is chosen which contains the information we are looking for, and it should be indicated that the inorganic DNA chains that have been developed for the memories are composed of two strands, as with their organic homologues. With these two localized premises, the following point is to determine what nucleotide or group of nucleotides we want to access, although the case may also arise when the user wants to access, at the same time, one part or the whole inorganic DNA chain, which has previously been localized. With this three-dimensional system that we have implemented for a volatile memory system, the basic technology explained in this document (*InChroSil*) has been used, which can easily be integrated in the existing technology, for the manufacturing of volatile memories. On the other hand, this characteristic of structuring makes the memory system of the invention be Innovative and novel, since a further dimension has been considered, the strand, whether principal or complementary, since in the previous systems of volatile memory, only two dimensions have been considered: rows and columns. Another characteristic of the invention is that it is possible to consider an inorganic DNA chain as a row or as a column, i.e. the system that administers the memory (IAM) may stipulate how the DNA chains would be stored in the memory, whether by rows or by columns. This memory system (IAM) is differentiated by its genetic character, due to the fact that, through inorganic materials, it is possible to store information on the organic DNA. Therefore, the existing volatile memories or RAM, In addition to being different due to access type, are also different due to the basic storage unit: bits or groups of bits for the case of the RAMs and nucleotides or groups of nucleotides for the case of our IAM memory. These memories can be integrated in the current systems or devices which require memory, for the simple reason that they can be manufactured with semiconductors and integrated in a circuit by micro-technology or nano-technology. Due to this, these memories can also be grouped in modules 21 with different connectors. These connectors vary with respect to the electronic devices or boards where the memories were connected, in this way, an inorganic genetic memory will be created with this structure based on the structure which has the same nature, for this reason, the memory access is much more interesting to access complete strands than a pair of specific nucleotides, essentially due to the form of linkage, separation, etc., of the actual nature of the organic DNA. As can be observed in figure 15, the memory system is formed by chains of inorganic DNA **12**, which in turn are formed by two strands, a main one and another complementary one. These strands of the memory are divided in nucleotides, which represent the basic storage unit **1** of these memories. Thus, in this way, when we want to localize a nucleotide or group of nucleotides, we should first localize the inorganic DNA chain, to then determine in what strand the information is in, to later establish what nucleotide or nucleotides within each strand we want to access. In figure 13, we show a scheme of one of these *InChroSil* units, which contains two nucleotides, which are complementary. Finally, we should indicate that, due to their genetic characteristics it would be possible to use these memories (IAM) to calculate intermediate or final operations, but always of temporary character, as is the case of calculating trajectories or resolving weighted graphs (Hamiltonian, Disjktra's, Eulerian paths, etc.), although It can also be extended to any type of information that needs information by generic encoding, i.e. by representation of DNA chains. A second memory which has been implemented for the invention is non-volatile memories, which are called in the invention *InChroSil* Read Only Memory (IROM), The information that this type of non-volatile memories contains is read-only and, as with IAM memory, previously described, its basic storage unit is the nucleotide, therefore, their access is structured as in the IAM.

Non-volatile memories have the particularity that they are read-only memories. IROM or read-only memories with *InChroSil* as with the IAM memories previously explained, have the same structure as in figure 15 and also the same previously explained access structure for IAM memories, a factor which also differentiates it from ROM or non-volatile memories existing at present. But this memory has the property that its information is read-only, therefore it is possible to implement by fuses or another system which allows us to create the static information, so that when a nucleotide is burned or created in this systems, the Inverse method, which has been described in the previous section, permits burning or creating the complementary nucleotide; in this way, we would follow the functioning indicated in figure 14. In this figure, reference **5** represents the primary information, reference **6** the inversion of said primary information, reference 7 the secondary information which is obtained and reference **8** the controls applied to achieve the correct functioning.

Finally, we should Indicate that this type of memory has a great use, due to the fact that Information can be stored which we want to remain static, such as, for example, the sequencing of our organic DNA, i.e. there is research where they try to store the organic DNA in a tube or device, but as it is organic material, it is difficult to store; with the non-volatile memory of the invention it is possible to store the information permanently and even be accessed from a computer or information system. Other applications can be forming a DNA database by IROM memory; there are databases which store DNA conventionally, by software, the memory of the invention permits the direct storage of this genetic information. In short, the use or functionality of this IROM memory can be highly varied and for various purposes, depending on the use for which it is desired to be used.

The configuration described permits resolving problems of routes, flows and networks, tackling them from the perspective of graph theory.

Routing problems are usually resolved by deterministic algorithms (reasonable time) and using software instead of hardware. This means that the systems choose devices which make predictive models, not real, on a possible approximate solution, i.e. in the market there is no device which can say to a drinks distributor, for example, what is the path whereby it would pass by each bar or restaurant of a city a single time and in optimum form. This problem cannot be resolved with the devices which currently exist, route, routing software, etc. In contrast, if It could be resolved, for the drinks' company and the distributor, there would be earnings and savings in time, respectively. Another example is the detection of faults or anomalies, by gas, electricity, water and telephone companies. On the market, there are positioning devices, using PLC, sensors, GIS, GPS, etc. but on a level of localization and routing, it is performed by software, in some cases and, in others, it is totally manual, where the operator, using the positional reference of the geographic areas, has to find the possible fault. For that reason, the use of a device in real time, which determines the position and calculates the shortest possible path to reach the fault point is crucial for the company's interests, since the problem can be resolved in less time. Also in industrial organization, where it is possible to optimize on a production level, the machinery or some processes and industrial machines, since we could represent the information and distribution of the industrial plant's machinery in a graph. In short, techniques and methodologies can be applied to every system that can be reduced or schematized to a representation in graph form to resolve problems in the field, where if it is considered that the encoding of the graph in DNA and with the use of the *InChrdSil* technology, problems can be resolved optimally, which previously could not have been resolved, in addition to having a device which can be integrated in the current systems, and its reuse is total, as commented in previous sections. Below, three problems are treated which are the keystone in calculating many of the aforementioned problems.

- Finding the shortest or most optimum route between two points.
- Resolving Traveling Salesman Problems.
- Obtaining Eulerian paths.

**Finding the shortest or most optimum route between two points.**

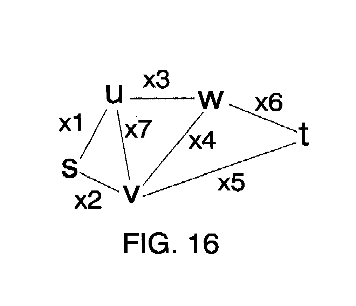

A typical problem of graph theory is to find the shortest or most optimal route from an initial point to an end point. The approach presented to this problem is to consider a directed graph, weighted (positive or negative) and using the characteristics of the DNA, by *InChroSil* technology. In this way, using a device based on *InChroSil* technology, it is possible to find the shortest or most optimal path. Let us give an example, supposing that we want to resolve the problem of figure 16 by the lists of adjacencies and set theory.

In the graph of figure 16, it is possible to represent as a list of adjacencies, where the nomenclature would be the following; (source vertex, edge, destination vertex), therefore, the graph would remain as follows.

Node(s): {(s,x1,u),(s,x2,v))
Node(u): {(u,x3,w),(u,x7,v)}
Node(v): {(v,x5,t)}
Node(w): {(w,x4,v),(w,x6,t)}

It should be highlighted that, in graph theory, the data structure, list of adjacencies, is defined as a structure which permits associating a list which contains all those vertices j, which are adjacent thereto, to each vertex i. In this way, space is saved in its representation and, in addition, the graph can be represented by a vector of n components (if |V|=n), where each component is going to be a list of adjacency corresponding to each one of the vertices of the graph, Furthermore, each element of the list consists of a field indicating the adjacent vertex. On the other hand, if the graph was labelled, it would be necessary to add a second field to show the value of the label.

Using set theory, we can form a set with all elements of the adjacency list, i.e. the elements (vertex, edge, vertex). This set that we have formed would have premises which are enumerated below.

- If there are two elements belonging to the set, such as $e_1$ and $e_2$, it is observed that the end component of $e_1$ is equal to the initial component of $e_2$, both elements react, creating a new element, which will belong to the set.
- If there are elements which belong to the set, which contain components which are initial and final, they do not react with the rest, since they would now be solution.
- Two elements that react have a positive ratio or 1, instead two elements which do not react have a negative ratio or 0.
- The elements with initial components and that belong to the adjacency lists, once reacted do not react again.

If it is known that E is the set of elements and C is the set of components, we can see that the reaction is the following operation:

$$\vee \; x \in C \; | \; \exists \; yax, xbz \in E \; \text{so that} \; yax \wedge xbz = yaxbz$$

with y, a, x, b $\in$ C and yaxbz $\in$ E.

In this case, we have a set of elements belonging to the adjacencies lists, which we will denote as Element[i], therefore, the set would initially remain in the following form.

Element1: {(s, x1, u)}
Element2: {(s, x2, v)}
Element3: {(u, x3, w)}
Element4: {(u, x7, v)}
Element5: {(w, x4, v)}
Element6: {(w, x6, t)}
Eiement7: {(v, x5, t)}

With this initial set, its elements can be analysed and it can be seen how these premise associated to the set can be fulfilled and new elements be created. In this case, it can be seen that Element1 would react with Element3 and Element4, forming Element8 and Eiement9. respectively. It can also be seen that Element2 reacts with Element7 to form Element10, which is now solution. After this, the set would remain as follows.

Element1: {(s, x1, u)} [does not react] premise 4
Element2: {(s, x2, v)} [does not react] premise 4
Element3: {(u, x3, w)}

Element4: {(u, x7, v)}
Element5: {(w, x4, v)}
Element6: {(w, x6, t)}
Element7: {(v, x5, t)}
Element8: {(s, x1, u, x3, w)}
Element9: {(s, x1, u, x7, v)}
Eiement10: {(s, x2, v, x5, t)}

In a following round, it is observed that Element8 can react with Element5 forming Element11 and, that also Element8 can react with Element6 to form Element12, finally, Element9 reacts with Element7 forming Element13. In this round the set would be as follows.

Element1: {(s, x1, u)} [does not react] premise 4
Element2: {(s, x2, v)} [does not react] premise 4
Element3: {(u, x3, w)}
Element4: {(u, x7, v)}
Element5: {(w, x4, v)}
Element6: {(w, x6, t)}
Element7: {(v, x5, t)}
Element8: {(s, x1, u, x3, w)}
Element9: {(s, x1, u, x7, v)}
Element10: {(s, x2, v, x5, t)}
Element11: {(s, x1, u, x3, w, x4, v)}
Element12: {(s, x1, u, x3, w, x6, t)}
Element13: {(s, x1, u, x7, v, x5, t)}

Observing the set, it is seen that there is a single reaction, that of Element11, which reacts with Element7 to form Element14. With this last reason, the set would be as follows.

Element1: {(s, x1, u)} [does not react] premise 4
Element2: {(s, x2, v)} [does not react] premise 4
Element3: {(u, x3, w)}
Element4: {(u, x7, v)}
Element5: {(w, x4, v)}
Element6: {(w, x6, t)}
Element7: {(v, x5, t)}
Element8: {(s, x1, u, x3, w)}
Element9: {(s, x1, u, x7, v)}
Element10: {(s, x2, v, x5, t)}
Element11: {(s, x1, u, x3, w, x4, v)}
Element12: {(s, x1, u, x3, w, x6, t)}
Element13: {(s, x1, u, x7, v, x5, t)}
Element14: {(s, x1, u, x3, w, x4, v, x5, t)}

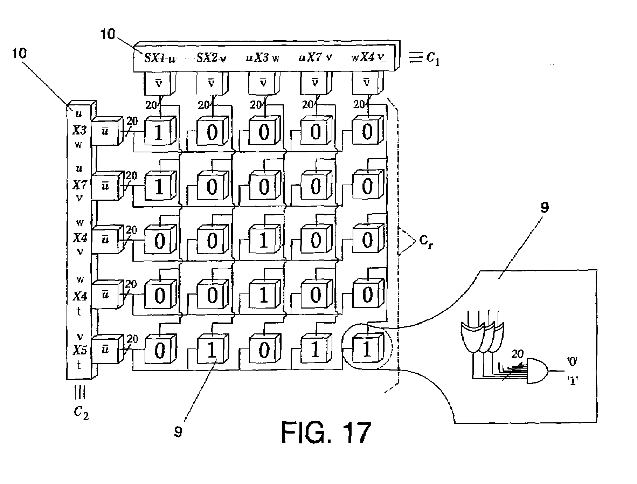

It can be seen that the results are Element10, Element12, Element13 and finally Element14, since they have initial and final components. The operation of this previous approach, to find the solutions or paths, is performed sequentially. But in the circuit of the Invention, It is performed in parallel form, i.e. the invention has considered two sets; the first set $C_1$ is formed by the elements which contain initial components and the elements that do not contain final components. The second set $C_2$ is formed by the elements that contain final components and the elements which do not contain initial components. Both sets are encoded by *Cod-InChroSil* and, stored In different strands **10**, respectively. These strands link their components by a circuiting which contains comparers **9**, forming a matrix as observed in figure 17; in this way, they react in parallel form, obtaining a set of reactions encoded as positive (1) or negative (0). These reactions form a matrix of 0s and 1s. Therefore, there are two sets $C_1$ and $C_2$, which represent the two aforementioned sets and which are encoded in *InChroSil* strands. On the other hand, we have a $C_r$, which is formed by the reactions between the elements of set $C_1$ and $C_2$; in this way, the reaction is redefined as the operation, where $e_2 \in C_2$ and $e_1 \in C_1$, then $e_1 \, \Re \, e_2 \in C_r$, with $\Re$ being the reaction and the values it may take are 0 or 1, As is observed, a new element is not created in the reaction which must react, but all react at the same time and it is indicated in a matrix, with a 1 if there had been a reaction or the reaction is positive and, in contrast, with a zero if there had not been a reaction or the reaction has been negative.

Once the matrix has been obtained with the reactions of all elements with all others, this information is passed to a buffer and, by software or circuitry, path recovery algorithms are applied to it, which do not have a very high cost and are of polynomial order. If weighted graphs are considered, the weights would be stored in a memory (*Mem-InChroSil* or another type of memory), therefore, the edges of the previous graph contain the direction and not the value of the weight, the motive why large quantities can be used for the weights and the directions have a determined length. Once the edges of the path have been found, it is only necessary to add the costs of each edge, to obtain the total cost of the path. Then with the total costs, the paths can be sorted according to a sorting criteria; all of this can be performed by circuitry or software modules, which would be connected with the device. This circuit resolves the problems posed In Dijkstra's, Floyd-Warshall and Bellman-Ford's and Ford-Fulkenson's algorithms, as they can consider negative costs, etc.

The advantage of these systems is the easy incorporation in existing hardware systems, since both are based on electronics and integrated circuits. On the other hand, it is a hardware alternative for the existing calculation systems, since with the software systems they need another environment (operating system, virtual machines, etc.) to function and, instead, this device would be connected directly to the circuitry of the host device.

**Resolving the Hamiltonian path problem.**

Current computing systems are based on a sequential technology established by *John Von Neumann* in the middle of the last century. These sequential computers are good at resolving mathematical problems, but they have difficulties with so-called *turnkey* problems, where all possible solutions have to be sought until the right solution is found. This means that the computing time of the problems becomes exponential or of logarithmic order.

Attempts have been made to mitigate these problems with the construction of parallel computers which can reduce the computing time. These solutions consume many resources in communications and number of interconnected nodes. For that motive, in the middle of 1994, Adleman presented a new alternative for programming with organic DNA, this organic system has a massive parallelism In the performance of operations and, therefore, obtaining the final results, but with the aforementioned limitations. He designed a system to resolve the Hamiltonian path problem with programming with organic DNA and, therefore, demonstrated that NP-Complete problems could be resolved in a computational time close to the polynomial. From this time on, a whole new programming philosophy arose with this organic material, which was called computing with DNA or molecular programming. But, throughout the years, and due to the material's characteristics, which is mainly perishable, the different experiments to transfer organic technology to the business world were unfruitful. To resolve these problems, this document presents a solution with electronic technology, in particular with *InChroSil* technology, an artificial proposal which emulates the behaviour of organic systems.

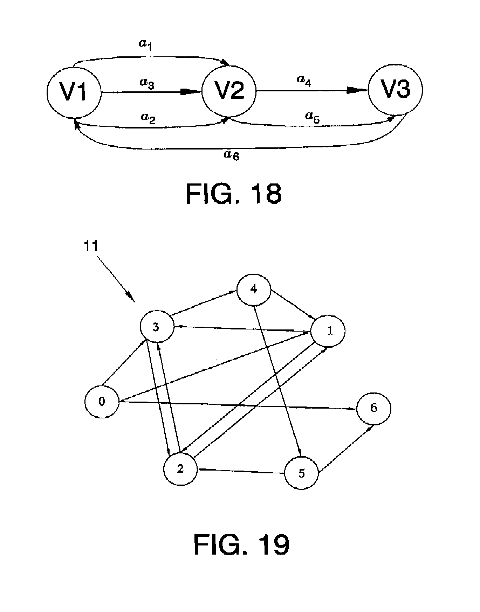

There are parallel implementations for the solution of the Hamiltonian path problem but they need a great volume of resources and communications between the connected nodes. The advantage that inorganic DNA has compared with sequential technologies is the great parallelism in the embodiment of the operations, for that reason the invention electronically resolves the Hamiltonian path problem. Based on the aforementioned characteristics, each city, the paths and complementary sequences which serve to link the paths with strands of DNA are encoded by the encoding stated in the document, see figure 19, where we can see graph **11** which represents Hamilton's problem, where the vertices are numbered from 0 to 6.

This problem is of great difficulty for deterministic problems with polynomial order, since it is a NP-Complete problem, but a non-deterministic algorithm can be formulated for the solution of this problem. The non-deterministic algorithm is presented in the following lines:

inputs: Graph, $V_{in}$ and Vout

- All paths existing in the graph are generated randomly.
- All the paths that comply with the inputs are eliminated.
- All those paths which do not have the required vertices are also eliminated.
- For each vertex, the paths are rejected which do not include the actual vertex.

Outputs: YES (If paths exist) NO (otherwise)

Therefore, in a conventional computer, the computing time cannot be polynomial, since it is necessary to compare all the cities one by one to find the path from an initial city $V_{in}$ to a final city $V_{out}$.

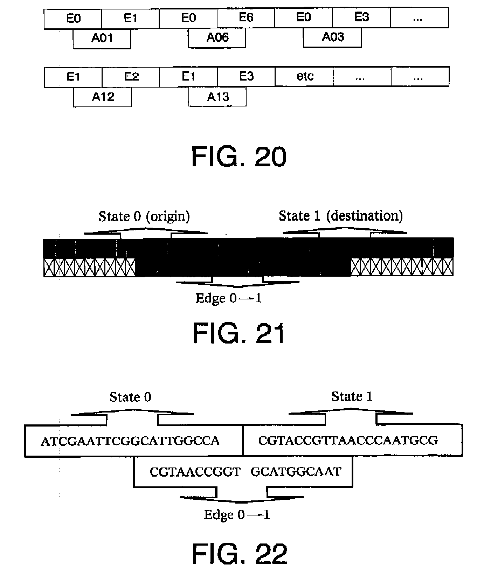

The electronic device which is explained below, was approached from the 7 vertex graph **11** of figure 19. This represents a directed graph which has a certain number of edges. The first step is encoding the graph of figure 19, for this the *Cod-InChroSil* encoding was used (explained in this document) and it was established that each city (vertex) had a determined number of nucleotides, for example, 20 nucleotides, and that the edges are composed of the same number, 20 nucleotides, which correspond to the last 10 nucleotides of a vertex or source city and the initial 10 nucleotides of the vertex or destination city. Therefore, using the *InChroSil* technology, a strand is created in which all edges represented in said graph will be housed. On the other hand, the strand must be able to encode all the edges of a complete graph of 7 vertices **11;** therefore, to give versatility to the experiment, said strand would offer the possibility, that in the worst of the cases compares a complete graph (a complete Graph is in Graph theory, a graph whose set of edges contain all possible edges, G=(V,vxV), with V the set that contains all vertices of the graph) and, in the best of the cases, for example, the graph shown In figure 19. This permits the programmer of the electronic circuit who performs the encoding to choose as many edges as he wants within the range established by the actual graph, i.e. for the graph of the example, there would be a strand of 5040 pairs of nucleotides (factorial of 7 if we consider 7 cities), so that the programmer would only require the activation of the complementary part of the strand in the edges necessary for the graph to analyse. In this case, complementarity would only be required with the parts of the strand that corresponded to the states which have an edge of the graph of figure 19, On the other hand, when encoding the graph of figure 19, it is called 'G' **17** (Graph) and can be seen in figure 20, wherein A0, A1.........represent the edges of the graph it links to the states (Ei), and wherein E0, E1......are the states of the cities of the problem posed.

Figure 21 graphically shows how the states are connected by edges and figure 22 details this encoding using cod-inchrosil. In figure 21, a state is formed by 20 nucleotides and an edge is composed of the final 10 nucleotides of one state and the initial 10 nucleotides of the following state.

The following step consists of being able to arrange all the possible existing Hamiltonian paths in a graph of 7 complete vertices, which meant a set of 5040 chains of DNA was created; of course with the *InChroSil* technology these strands will be composed of 140 pairs of nucleotides (since there are 7 vertices and each one of them must be represented by 20 pairs of nucleotides, a strand length would be required of 7 by 20). These strands were disposed in matrix form because it was more convenient to be able to approach a three-dimensional chip, and continue In the line of being able to emulate the organic nature. This encoding, as with the example graph, was called 'CG' **18** (Set of Graphs).

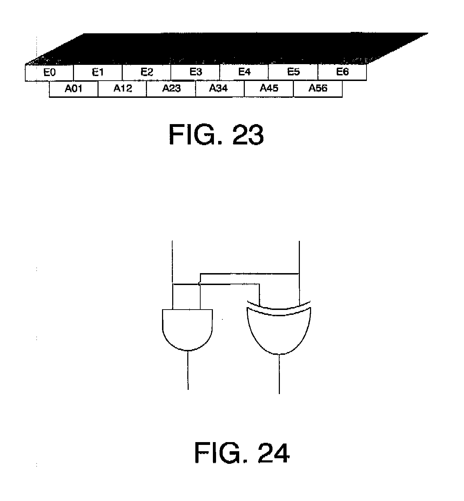

Set theory is especially used to delimit the scope of a proposal, which forces the object of the proposal to remain in a certain measure concretized. This is desirable as it permits operating with the formed proposal, at the beginning at least a level of true of false, and at maximum, depending on how the parameterization of the established proposals corresponds, i.e. a set S is defined if, given any object *a*, it is known with certainty whether It belongs to the set or not. Therefore, this theory applied to this project permits comparing each edge of 'CG' of figure 23 of a set of strands, which represent all possible combinations of the states with each edge specified in graph 'G' of figure 20, totally parallel and determining, in this way, if said edge of graph 'CG' belongs or not to the set of edges encoded in graph 'G', therefore, the edges of graph 'G' become sets and, in turn, the edges of graph 'CG' become objects of which it should be known with certainty if they belong or not to the set stated by the programmer, i.e. to graph 'G', since 'CG' are templates of possible solutions, To be able to perform these comparisons, the philosophy of logical half-adders, carry-save adders (CSA) and Wallace trees was used. These technologies simply acknowledged in the field of computer structures, offer the possibility of creating modifications in the designs to obtain the parallelism required by the problem and in this obtain the desired results. On the other hand, as observed in figure 24, the internal structure of a standard logical half-adder can be seen

A modification which is present in this document is the elimination of the carry, only leaving the direct addition of the two inputs, if we take into consideration the truth table of a XOR port, it can be observed that if the two bits are the same the logical result is 0, for which reason this project chooses to reject said output, in this way, direct and not inverse logic would be worked with. Due to this approach, comparers **12** are developed by XNOR ports **12a** to resolve the problem. On the other hand, the fact of joining together 40 XNOR ports **12a** (since the edges are of 20 pairs of nucleotides, this entails 40 bits per edge and, therefore, 80 inputs, since it will be compared two by two), arose from the idea of being able to create CSA (carry-save adder, which permits performing additions obtaining as a result the addition of data and the carry), i.e. the linking of XNOR ports **12a** giving a unique result of 40 bits.

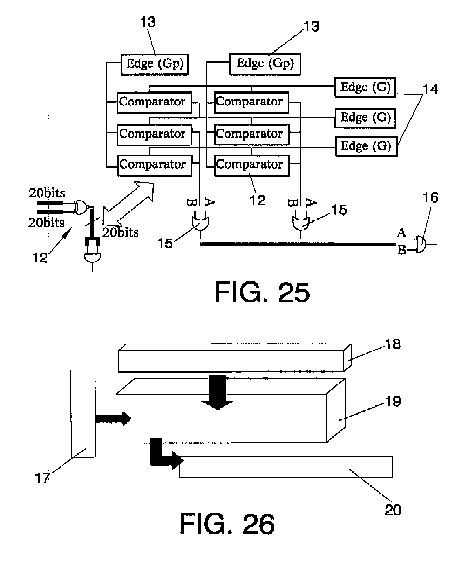

But these ports offered a 40 bit result, which was not optimum, for which reason the following questions were posed: Are all the bits the same? Are they the same edge?, for this a 40 Input AND port **12b** and 1 single response bit was used, obtaining in a single datum the response to our questions. Since if this AND port **12b,** gives a '1' as logical result, this would mean that the edges are the same and, therefore, said edge belongs to graph 'CG', and therefore, it would belong to the set of edges belonging to graph 'G'. In contrast, if the value is '0', it would mean that the mentioned edges are not the same, but they do not guarantee that they do not belong to the programmed set, which was a datum to resolve. Therefore, an encapsulation of the circuit was created the same as the CSAs, creating in this way the comparer **12** shown in figure 25.

To be able to resolve this problem, the comparers **12** are established creating a matrix and comparing the edges **13** and **14,** two by two, of both graphs ('G' and 'CG') in parallel form. But, a new question arises, How to establish if this is path or not?, to be able to respond to this question they considered the already known Wallace trees, although their structure or operating philosophy was not used, which is creating different levels of requirement to be able to find the result required in a totally parallel form.

Therefore, it was considered that If it was required that each comparer in columns of said matrix of comparers, its equal result **12** was directed towards an OR port **15,** so that if any of the comparers responded to logical '1', said logical port **15** corresponding to the column, would confirm in parallel the belonging of said edge to the set of programmed edges. In this way, said levels of the Wallace trees are created.

Finally, all these OR logical ports **15,** which in this case are as many as columns or edges existing In the *InChroSi*l DNA STRANDS, belonging to graph 'CG', i.e. 6 OR logical ports **15.** In this way, if all the edges confirm the belonging to the set, they represent a Hamiltonian path, this is achieved by directing all the outputs towards an AND logical port **16,** in this way the response desired is definitively obtained, thus the final level of requirements is created.

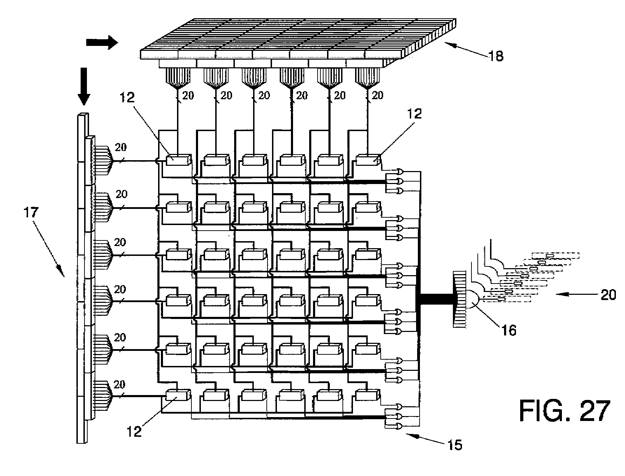

Finally, the result of the AND port **16** is stored in a non-represented results vector, so that this vector would have 5040, i.e. as many as strands of *InChroSi*l, have been encoded, for which reason the positions wherein a logical '1' is reflected, would reflect that the strand encoded in said position of the vector is a Hamiltonian path of the graph presented, in figure 26 a simplified diagram of the circuit is shown, and in figure 27 we can see the complete circuit.

**Resolving traveling salesman problems.**

The traveling salesman problem (TSP) is one of the most famous and best studied in the field of computational optimization. Despite the apparent simplicity of its approach, the problem is one of the most difficult to resolve, since it is considered of NP-Complete complexity. The invention resolves the problem of the travelling salesman with an electronic system (previous section), with a temporary cost of polynomial order. This system has a weighted and directed graph, where all the Hamiltonian paths existing in the graph are obtained. Therefore, in the most favourable case, there is only one path, but in the contrary case or opposite pole, in the unfavourable case, i.e. when there is a complete graph, we can have all the Hamiltonian paths. As already commented, the calculation of all the paths is performed in parallel, but what the circuit of the previous section did not contemplate was the weight of the edges, to resolve the weighted Hamiltonian problems. The idea approached in this document to give a solution to the weighted Hamiltonian problems is simple. Using the same electronic infrastructure provided for the calculation of Hamiltonian paths, but also taking two implementations into consideration; the first implementation in figure 28 Is to transfer this information (paths found) to a software system **23, 26** which determines the correspondence between weight-edge. This system, once the individual cost is obtained, calculates the total cost of each path. Finally, when the costs of all the Hamiltonian paths are calculated, to order them according to a determined criteria (from least to greatest, from greatest to least, etc.). All these operations have to bear in mind that the information is encoded in *Cod-InChroSi*l and that the assignment of weights to the edges and the subsequent cost calculation is not a costly work on a computational level, since it has polynomial times. Finally, the user or a system will have a collection of ordered paths, and then it will depend on it to choose the best path. In this figure 28, reference **21** represents the circuit to obtain the Hamiltonian path, **22** the connection interface with interface **25** of a data processing module **23,** reference **24** is a database and **26** a cost and sorting calculation module. Reference **27** represents an external data request device.

On the other hand, the intermediate date was stored In the database of the invention, i.e. the weights of the edges, etc. For which reason it serves as support to the calculations which are going to be made or are have been made.

Another implementation shown in figure 29 is the use of memories **28** (*Mem-InChroSi*l or another type of memory), the idea is that when all the *InChroSi*l vertices are encoded and, therefore the value of the edges the link are established, the system will store in that memory address (value of the edge), the value of the weight of that edge In the graph, i.e. it does not store its value or weight in the edge, but the memory address where its value is located, due to the fact that this value can be a very large number and the addresses have an established size. When the Hamiltonian paths are determined, by the previous circuit **21,** it seeks the value of the edges in the memory **28,** since as we know its address, we will know its value. These costs are added and will be looked for by circuitry mediation, i.e. a bus **32** and adders **30,** to obtain the total cost of each path which can be stored in the memory **28** with consecutive addresses. As in the previous implementation, the user or the system which receives this information as input, chooses with which path it remains, by criteria of choice, outside the devices described in this document. In this example, reference **22** represents the connection interface with an interface **25a** of the data processing module **23a,** reference **29** the sorting module, **31** a connection interface of module **23a** with a data fetching device **27.**

Finally, we should indicate that problems of Hamiltonian cycles can also be resolved, for which purpose it would be necessary to consider the premise that the output vertex is the same as the destination vertex.

**Obtaining Eulerian paths**

Eulerian paths are those paths that run through all vertices of a graph passing just once through each edge of the graph, one of the main conditions being that it returns to the initial or output vertex; therefore, a Eulerian path is a cycle which contains all edges of a graph just once. This problem was posed and resolved by Leonhard Euler himself in 1736 In a problem which has the name of the seven bridges of the city of Königsberg. The problem is enunciated in the following form: two islands in the Pregel river, in Königsberg are joined together and with land by seven bridges. Is it possible to take a walk starting by any of the four parts of land, crossing each one of the bridges just once?

Euler approached the problem representing each part of land by one point and each bridge by a line, joining the corresponding dots. Then, the previous problem can be transferred to the following question: Is it possible to travel round the representation without repeating the lines? Euler demonstrated that it was not possible because the number of lines that affect each dot is uneven (a necessary condition to be able to enter and exit each dot). Therefore, this problem posed questions such as the following; How is it possible to cover the cable of this electricity grid without repeating sections of grid? How can this route be performed, passing through specific streets?, etc.

As has been seen, there is a complexity in resolving these problems, for that reason the problem could be considered inversely, i.e. what were vertices become edges and the edges become vertices. With this conversion, we can apply or calculate the Hamiltonian paths, since now the vertices represent the edges and it Is necessary to know what sequence of vertices we should follow to be able to pass through all the edges. Let us suppose the directed and non-weighted graph of figure 18, which would be a multi-graph, i.e. a non-deterministic automaton.

The graph of figure 18 can also be represented as follows, where $V_1$ is the set of vertices and $E_1$ is the set of edges.

$$G_1 = (V_1, E_1) \text{ with } V_1 = (v_1, v_2, v_3) \text{ and } E_1 = (a_1, a_2, a_3, a_4, a_5, a_6)$$

Furthermore, we have the following vertex links, by means of edges;

$$U = \{(v_1, v_2, a_1), (v_1, v_2, a_2), (v_1, v_2, a_3), (v_2, v_3, a_4), (v_2, v_3, a_5), (v_2, v_3, a_6), (v_3, v_1, a_6)\}$$

Where the nomenclature used for these links is (source vertex, destination vertex, edge). If said Inversion is made, and if the edges are considered as vertices and the vertices as edges, we would obtain the following graph.

$$G_2 = (V_2, E_2) \text{ with } V_2 = (a_1, a_2, a_3, a_4, a_5, a_6) \text{ and } E_2 = ((v_1, v_2), (v_2, v_3), (v_3, v_1))$$

Furthermore, we have the following vertex links, by means of edges;

$$W = \{(a_1, v1, v2, v2, v3, a4), \ldots\}$$

Therefore, the graph will have the form shown in figure 18. Consequently, if the Hamiltonian path of the previous graph $G_2$ is shown, it can be stated that there Is a solution or Eulerian path $G_1$. It can also be considered that the graph is weighted, the total costs of each one of the paths can be calculated and, therefore, sorted by cost, although the Eulerian paths do not have weight, new problems of optimization in the Eulerian paths could be posed. In conclusion, if a Hamiltonian path exists in graph $G_2$ it can be stated that there is a Eulerian path in graph $G_1$. Finally, it can be stated that Eulerian cycles can be resolved, for which purpose, when encoding the base of strands or banks of strands, it was established that the initial node was the same as the final. In this way, cycle problems can be resolved using the invention.

**Claims**

1. **ELECTRONIC SYSTEM TO EMULATE THE CHAIN OF THE "DNA" STRUCTURE OF A CHROMOSOME**, whose chain comprises two strands, each one of them constituted by a chain of nucleotides, which comprise Adenine (A), Guanine (G), Cytosine (C) and Thymine (T); so that complementary linkages are produced between said strands, which are performed by the linking of Adenine (A) with Thymine (T) and Guanine (G) with Cytosine (C); wherein it comprises means of binary encoding of the four different types of nucleotides which compose the strands, so that complementary codes are assigned to the nucleotides which form complementary linkages, by the Inversion of one of them; and including storage units of a code of a nucleotide and selectively of a code selected from its complementary code and no code; to obtain a nucleotide and selectively its complement; connecting said storage units in series, to form the chain of nucleotides which constitute each strand of a "DNA" chain, and thus obtain its electronic structure and permit the selective access to a nucleotide and selectively to its complement, to a strand and to the two strands of the "DNA" chain.

**2.  ELECTRONIC SYSTEM TO EMULATE THE CHAIN OF THE "DNA" STRUCTURE OF A CHROMOSOME,** according to claim 1, wherein different modules are provided, each one constituted by groupings of storage units, wherein, in each module a "DNA" chain is stored, the modules being connected in rows and columns to access each "DNA" chain by selection of rows or columns.

**3.  ELECTRONIC SYSTEM TO EMULATE THE CHAIN OF THE "DNA" STRUCTURE OF A CHROMOSOME,** according to claims 1 or 2, wherein the binary code assigned to each nucleotide comprises two bits and its storage depends on the inputs applied to each storage unit.

**4.  ELECTRONIC SYSTEM TO EMULATE THE CHAIN OF THE "DNA" STRUCTURE OF A CHROMOSOME,** according to claims 1, 2 or 3, wherein it comprises means of encoding of numeration at base 4 composed of the four nucleotides of "DNA".

**5.  ELECTRONIC SYSTEM TO EMULATE THE CHAIN OF THE "DNA" STRUCTURE OF A CHROMOSOME,** according to claim 4, wherein the two bits corresponding to each nucleotide acquire the decimal quantities of 0 to 3, to form a plurality of numerical representations determined by the position of the two bits and the value they receive.

**6.  ELECTRONIC SYSTEM TO EMULATE THE CHAIN OF THE "DNA" STRUCTURE OF A CHROMOSOME,** according to claim 5, wherein it comprises means to perform operations selected from additions, subtractions, multiplications and divisions; and comprises encoding any single or double-precision fixed or floating point number.

**7.  ELECTRONIC SYSTEM TO EMULATE THE CHAIN OF THE "DNA" STRUCTURE OF A CHROMOSOME,** according to claim 1, wherein the storage units are selected from volatile (IAM) and non-volatile (IROM) memories.

**8.  ELECTRONIC SYSTEM TO EMULATE THE CHAIN OF THE "DNA" STRUCTURE OF A CHROMOSOME,** according to claims 2 and 7. wherein it comprises means of access structured by the localization of a "DNA" chain, after localization of a strand and after selective designation of a nucleotide or group of nucleotides.

**9.  ELECTRONIC SYSTEM TO EMULATE THE CHAIN OF THE "DNA" STRUCTURE OF A CHROMOSOME, according to preceding claims, wherein it** comprises means for encoding in the storage units which form strands, representations of problems by graphs which comprise elements constituted by vertices and edges and selectively weight (direction); to encode in a strand a first set which contains elements of the graph constituted by vertices and edges corresponding to initial elements and that corresponding to the elements which do not contain final elements; and in the complementary strand is encoded a second set which contains elements of the graph constituted by final elements and those elements corresponding to the elements which do not contain final; each storage unit being of both strands joined together by comparers which form a matrix to perform the comparison between all elements of both sets in parallel and resolve problems which may be represented by graphs.

**10.  ELECTRONIC SYSTEM TO EMULATE THE CHAIN OF THE "DNA" STRUCTURE OF A CHROMOSOME,** according to claim 9, wherein the comparers which form a matrix are connected to a buffer whereto path recovery means of polynomial order are applied to determine the most optimum route between two points of the graph.

**11.  ELECTRONIC SYSTEM TO EMULATE THE CHAIN OF THE "DNA" STRUCTURE OF A CHROMOSOME,** according to claim 10, wherein it comprises additional storage means of the weight of an edge, means to add the weights of each edge and obtain the total weights of each edge, and means of sorting the total weights of each edge, according to previously established criteria to resolve algorithm problems selected from Dijkstra, Floyd-Warshall, Bellman-Ford and Ford-Fulkenson.

**12.  ELECTRONIC SYSTEM TO EMULATE THE CHAIN OF THE "DNA" STRUCTURE OF A CHROMOSOME,** according to claim 9, wherein it is applied in flow problems selected from vehicle fleets, optimization of industrial vehicles, optimization of industrial processes, work flows, problems of coupling and communications networks.

**13.  ELECTRONIC SYSTEM TO EMULATE THE CHAIN OF THE "DNA" STRUCTURE OF A CHROMOSOME,** according to claim 9, wherein it comprises means for encoding a Hamiltonian path problem in storage units which constitute two strands, in one of which the complete graph is encoded and in the complement the complete graph with known restrictions; the strands being connected to comparers forming a matrix to compare the edges of both graphs two by two in parallel for to indicate if the two bits of the result of each comparison are all equal and refer to the same edge and, in consequence, belongs to both graphs; applying the result of the comparison to means to create Wallace tree levels indicative of whether the edge is path or not.

14. **ELECTRONIC SYSTEM TO EMULATE THE CHAIN OF THE "DNA" STRUCTURE OF A CHROMOSOME**, according to claim 13. wherein the comparers which compare the edges two by two, comprise logical carry-save half-adders, whose output is connected to a logical detection port of a single bit of the result of the comparison to obtain a single datum.

15. **ELECTRONIC SYSTEM TO EMULATE THE CHAIN OF THE "DNA" STRUCTURE OF A CHROMOSOME**, according to claim 14, wherein the means to create Wallace tree levels comprise first logical ports for each column of the unit of comparers, which represent the complete graph, and connected to its outputs, to confirm the belonging of said edge of the graph with restrictions, indicating whether it is path or not.

16. **ELECTRONIC SYSTEM TO EMULATE THE CHAIN OF THE "DNA" STRUCTURE OF A CHROMOSOME**, according to claim 14, wherein the outputs of the first logical ports are connected to a second logical port of detection of whether all the edges are path, determining the Hamiltonian path, and including the means of storage of the result obtained.

17. **ELECTRONIC SYSTEM TO EMULATE THE CHAIN OF THE "DNA" STRUCTURE OF A CHROMOSOME**, according to claims 3 and 16, wherein it comprises means to receive the paths found and establish in correspondence between weight and edge and obtain the weights of each path, and including means of sorting the weights of the paths according to previously established criteria, for the choice of the best path.

18. **ELECTRONIC SYSTEM TO EMULATE THE CHAIN OF THE "DNA" STRUCTURE OF A CHROMOSOME**, according to claim 15, wherein it comprises additional storage memories of the weight of the edges to establish the correspondence between weight and edge, by the storage of the memory address referring to the encoding of vertices, adding the weights to obtain the totals of each path that are stored in the additional memories with consecutive addresses, and by means or sorting the weights of the paths, according to previously established criteria, establishes the choice of the best path.

19. **ELECTRONIC SYSTEM TO EMULATE THE CHAIN OF THE "DNA" STRUCTURE OF A CHROMOSOME**, according to claim 18, wherein it is applied to the resolution of Hamiltonian cycles by indicative encoding that the output vertex of the graph is the same as the destination vertex.

20. **ELECTRONIC SYSTEM TO EMULATE THE CHAIN OF THE "DNA" STRUCTURE OF A CHROMOSOME**, according to claim 9, wherein it comprises means for encoding a graph so that the vertices represent the edges and the edges the vertices, and thus obtain the sequence of vertices which they must follow to pass through all the edges and enable resolving the problem of the Eulerian path.

21. **ELECTRONIC SYSTEM TO EMULATE THE CHAIN OF THE "DNA" STRUCTURE OF A CHROMOSOME**, according to claim 20, wherein they comprise means to establish encoding of the weight of the edges and pose new optimization problems in the Eulerian paths.

22. **ELECTRONIC SYSTEM TO EMULATE THE CHAIN OF THE "DNA" STRUCTURE OF A CHROMOSOME**, according to claims 20 or 21, wherein it comprises means for encoding in the strands that the initial vertex is the same as the final vertex to resolve Eulerian cycles.

FIG. 1

FIG. 2

FIG. 3

EP 2 180 434 A1

| Decimal | Binary | Octal | Hexadecimal | In Chro Sil |
|---------|--------|-------|-------------|-------------|
| 0 | 00 | 0 | 0 | A |
| 1 | 01 | 1 | 1 | G |
| 2 | 10 | 2 | 2 | C |
| 3 | 11 | 3 | 3 | T |
| 4 | 100 | 4 | 4 | GA |
| 5 | 101 | 5 | 5 | GG |
| 6 | 110 | 6 | 6 | GC |
| 7 | 111 | 7 | 7 | GT |
| 8 | 1000 | 10 | A | CA |
| 9 | 1001 | 11 | B | CG |
| 10 | 1010 | 12 | G | CC |
| 11 | 1011 | 13 | D | CT |
| ... | ... | ... | ... | ... |

## FIG. 4

|   | *A* | *G* | *C* | *T* |
|---|-----|-----|-----|-----|
| *A* | A | G | C | T |
| *G* | G | C | T | GA |
| *C* | C | T | GA | GG |
| *T* | T | GA | GG | GC |

## FIG. 5

|   | *A* | *G* | *C* | *T* |
|---|-----|-----|-----|-----|
| *A* | A | GT | GC | GG |
| *G* | G | A | GT | GC |
| *C* | C | G | A | GT |
| *T* | T | C | G | A |

## FIG. 6

|   | T | G | A | T | number 1 |
|---|---|---|---|---|----------|
| - | G+G=C | C+G=T | C | C | number 2 |
|   | G | \ C | \ C | G | result |

## FIG. 7

|   | A | G | C | T |
|---|---|---|---|---|
| A | AA | AA | AA | AA |
| G | AA | AG | AC | AT |
| C | AA | AC | GA | GC |
| T | AA | AT | GC | CG |

# FIG. 8

|   |   | GTTG | number 1 |
|---|---|------|----------|
| X |   | GGA | number 2 |
|   |   | AA | product G  X A |
|   |   | AAA | product  T  X A(*) |
|   |   | AAAA | product  T  X A(*) |
| + |   | AAAAA | product  G X A(*) |
|   |   | AAAAA | Partial sum |
|   |   | AGA | product  G  X G |
|   |   | ATAA | product  T  X G(*) |
|   |   | ATAAA | product  T  X G(*) |
| + |   | AGAAAA | product  G X G(*) |
|   |   | AGTTGA | Partial sum |
|   |   | AGAA | product  G  X G |
|   |   | ATAAA | product  T  X G(*) |
|   |   | ATAAAA | product  T  X G(*) |
| + |   | AGAAAAA | product  G X G(*) |
|   |   | ACGTAGA | Final result  (2500 in decimal) |

(*) A' s area added on the right

# FIG. 9

| Sign | Strand | Cod | Exp | Hebra | Cod | Mantiss |
|---|---|---|---|---|---|---|
| 1 | 1 | 1 | 4 | 1 | 1 | 11 |

## FIG. 10

| Strand | Fixed point + sign | Complement A1 | Complement A2 | Excess $4^4$ |
|---|---|---|---|---|
| Strand1 | GTTT $(+127_{10})$ | GTTT $(+127_{10})$ | GTTT $(+127_{10})$ | TTTT $(+127_{10})$ |
| Strand2 | CAAA $(+0_{10})$ | CAAA $(-127_{10})$ | CAAA $(-128_{10})$ | AAAA $(-128_{10})$ |
| Strand1 | ... | ... | ... | ... |
| Strand2 | ... | ... | ... | ... |
| Strand1 | AAAA $(+0_{10})$ | AAAA $(+0_{10})$ | AAAA $(+0_{10})$ | CAAA $(+0_{10})$ |
| Strand2 | TTTT $(-127_{10})$ | TTTT $(-0_{10})$ | TTTT $(-1_{10})$ | GTTT $(-1_{10})$ |
| Strand1 | CAAA $(-0_{10})$ | TTTT $(-0_{10})$ | AAAA $(-0_{10})$ | CAAA $(+0_{10})$ |
| Strand2 | GTTT $(+127_{10})$ | AAAA $(+0_{10})$ | TTTT $(-1_{10})$ | GTTT $(-1_{10})$ |
| Strand1 | ... | ... | ... | ... |
| Strand2 | ... | ... | ... | ... |
| Strand1 | TTTT $(-127_{10})$ | CAAA $(-127_{10})$ | CAAG $(-127_{10})$ | AAAG $(-127_{10})$ |
| Strand2 | AAAA $(+0_{10})$ | GTTT $(+127_{10})$ | GTTC $(+126_{10})$ | TTTC $(+126_{10})$ |
| Strand1 | | | CAAA $(-128_{10})$ | AAAA $(-128_{10})$ |
| Strand2 | | | GTTT $(+127_{10})$ | TTTT $(+127_{10})$ |

## FIG. 11

| Sign | Strand | Cod | Exp | Strand | Cod | Mantiss |
|------|--------|-----|-----|--------|-----|---------|
| 1    | 1      | 1   | 7   | 1      | 1   | 28      |

## FIG. 12

## FIG. 13

FIG. 14

DATA

SEL $_0$

SEL $_1$

5

6

7

8

OE

WE

CS

WRITE/READ

# FIG. 15

DATA

4

SEL$_1$
SEL$_0$
READ
WRITE
GND
+5

1

1

21

21

FIG. 16

FIG. 17

FIG. 18

FIG. 19

| E0 | E1 | E0 | E6 | E0 | E3 | ... |
|----|----|----|----|----|----|-----|

| A01 | A06 | A03 |

| E1 | E2 | E1 | E3 | etc | ... | ... |
|----|----|----|----|-----|-----|-----|

| A12 | A13 |

## FIG. 20

State 0 (origin)    State 1 (destination)

Edge 0 → 1

## FIG. 21

State 0    State 1

| ATCGAATTCGGCATTGGCCA | CGTACCGTTAACCCAATGCG |
|----------------------|----------------------|

| CGTAACCGGT  GCATGGCAAT |

Edge 0 → 1

## FIG. 22

| E0 | E1 | E2 | E3 | E4 | E5 | E6 |
|----|----|----|----|----|----|----|
| A01 | A12 | A23 | A34 | A45 | A56 | |

FIG. 23

FIG. 24

FIG. 25

FIG. 26

FIG. 27

21

Data processing
module

23

24

27

22

25

**FIG. 28**

26

21

Data processing
module

28

22

(1)

27

(2)

25a

32

23a

29   30

31

**FIG. 29**

## INTERNATIONAL SEARCH REPORT

| International application No. |
| --- |
| PCT/ ES 2007/000478 |

| A. CLASSIFICATION OF SUBJECT MATTER |
| --- |
| see extra sheet |
| According to International Patent Classification (IPC) or to both national classification and IPC |

| B. FIELDS SEARCHED |
| --- |
| Minimum documentation searched (classification system followed by classification symbols) |
| G06N, G11C |
| Documentation searched other than minimum documentation to the extent that such documents are included in the fields searched |
| Electronic data base consulted during the international search (name of data base and, where practicable, search terms used) |
| EPODOC, WPI, TXTEN, Internet |

C. DOCUMENTS CONSIDERED TO BE  RELEVANT

| Category* | Citation of document, with indication, where appropriate, of the relevant passages | Relevant to  claim No. |
| --- | --- | --- |
| X | FR 2071924 A5 (IBM) 24.09.1971, page 1, line 12 - page 2, line 28;page 3, line 19 - | 1-8 |
| Y | page 5, line 39; claims 1-2; figures 1-3D. | 9-22 |
| A | Quaternary numeral system. [online] English Wikipedia. Revisión of 16.05.2007 [retrieved on 22.04.2008] Retrieved from the Internet <URL:http:// en.wikipedia.org/w/index.php?title= Quaternary_numeral_system&oldid=131196098> | 1 |
| Y | ADLEMAN, L.M. Molecular Computation of Solutions to Combinatorial Problems. Science, New series. 11.10.1994, Vol. 266, N°. 5187, pages 1021- 1024. | 9-22 |

☐ Further documents are listed in the continuation of Box C.          ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance. | | |
| "E" | earlier document but published on or after the international filing date | | |
| "L" | document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" | document referring to an oral disclosure use, exhibition, or other means | "Y" | document of particular relevance; the claimed invention cannot be considered to involve an inventive step when the document is combined with one or more other documents , such combination being obvious to a person skilled in the art |
| "P" | document published prior to the international filing date but later than the priority date claimed | | |
| | | "&" | document member of the same patent family |

| Date of the actual completion of the international search | Date of mailing of the international search report |
| --- | --- |
| 24.April.2008        (24.04.2008) | (30/04/2008) |
| Name and mailing address of the ISA/ O.E.P.M. <br><br> Paseo de la Castellana, 75 28071 Madrid, España. <br> Facsimile No.   34 91 3495304 | Authorized officer <br><br> A. Figuera González <br><br> Telephone No. +34 91 349 55 16 |

Form PCT/ISA/210 (second sheet) (April 2007)

INTERNATIONAL SEARCH REPORT

Information on patent family members

International application No.

PCT/ ES 2007/000478

| Patent document cited in the search report | Publication date | Patent family member(s) | Publication date |
|---|---|---|---|
| FR 2071924 AB | 24.09.1971 | DE 2062211 A | 24.06.1971 |
| | | DE 2038483 A | 24.06.1971 |
| | | US 3638204 A | 25.01.1972 |
| | | US 3643236 A | 15.02.1972 |
| | | GB 1316300 A | 09.05.1973 |
| | | GB 1323733 A | 18.07.1973 |
| | | CA 935937 A | 23.10.1973 |
| | | JP 50028300 B | 13.09.1975 |
| | | JP 51026015 B | 04.08.1976 |

Form PCT/ISA/210 (patent family annex) (April 2007)

INTERNATIONAL SEARCH REPORT

International application No.

PCT/ ES 2007/000478

CLASSIFICATION OF SUBJECT MATTER

*G06N 3/12* (2006.01)
*G11C 8/16* (2006.01)

**REFERENCES CITED IN THE DESCRIPTION**

**Patent documents cited in the description**

•   US 7167847 B